# EUROPEAN PATENT APPLICATION

(11) **EP 4 794 196 A1**
(43) Date of publication of application: **19.08.2026**
(21) Application number: 26155569.2
(22) Date of filing: 30.01.2026
(51) Int. Cl.: H03F 3/217, H03F 3/187

(54) **A SWITCHING CIRCUIT, CORRESPONDING DEVICE AND METHOD**

(30) Priority: 17.02.2025 IT 202500003012
(71) Applicant: STMicroelectronics International N.V., 1228 Plan-les-Ouates, Geneva (CH)
(72) Inventor: GONANO, Giovanni, I-20153 Milano (IT); BOTTI, Edoardo, I-29029 Vigevano (Pavia) (IT)
(74) Representative: Buzzi, Notaro & Antonielli d'Oulx S.p.A.

(57) **Abstract**

A circuit, comprising: a switching circuit stage comprising first and second half bridges comprising a first, high-side DMOS transistor and a second, low-side DMOS transistor, the first half bridge (HB1) and the second half bridge (HB2) comprising respective output nodes between the high-side DMOS transistor and the low-side DMOS transistor therein, the output nodes configured for supplying an electrical load via respective filter networks between the output nodes and the load; control circuitry (60) coupled to the switching circuit stage and configured to control switching sequences of the high-side and low-side transistors in the first (HB1) and second (HB2) half bridges wherein a first pair of DMOS transistors comprising the high-side DMOS transistor in one (HB2 resp. HB1) of the half bridges (HB1, HB2) and the low-side DMOS transistor in the other of the half bridges (HB1, HB2) is switched to a non-conductive state, and a second pair of transistors comprising the high-side DMOS transistor in the other (HB1 resp. HB2) of the half bridges (HB1, HB2) and the low-side DMOS transistor (L2 resp. L1) in the one (HB2 resp. HB1) of the half bridges (HB1, HB2) is switched to a conductive state. The circuit comprises: a current flow line between the output nodes in the first half bridge (HB1) and the second half bridge (HB2), the current flow line comprising an inductance having opposed terminals coupled to a first switch and a second switch, the first switch and the second switch selectively switchable between a non-conductive state and at least one conductive state; first and second capacitances coupled with the output nodes of the first half bridge (HB1) and the second half bridge (HB2). The control circuitry (60) is configured to switch the first and second switches to the at least one conductive state at intervals in said switching sequences between switching the first pair of DMOS transistors to a non-conductive state and switching the second pair of DMOS transistors to a conductive state. The control circuitry (60) is configured to provide control signals to switch at least one of said first and second switches based on a delay among a first output signal at said first output node and a second output signal at said second output node.

## Description

### Technical field

The description relates to switching circuits. One or more embodiments may be applied e.g. to switching (Class D) audio power amplifiers.

### Technological background

Efficiency and (low) distortion are figures of merit in switching circuits such as class D audio power amplifiers.

A fixed frequency class D bridge audio amplifier with reduced switching losses, ZSL and reduced total harmonic distortion, THD is known from document US 2019/238094 A1 which discusses a ZSL switching circuit including a switching circuit stage configured to supply a load via filter networks. Control circuitry is provided to control alternate switching sequences of transistors in the half-bridges of the switching circuit stage. A current flow line is provided between the output nodes of the half-bridges including an inductance between two switches. First and second capacitances are coupled with the output nodes of the half-bridges. The control circuitry switches first and second switches to the conductive state at intervals in the alternate switching sequences of the transistors in the half-bridges between switching the first pair of transistors to a non-conductive state and switching the second pair of transistors to a conductive state.

In power stages using a silicon technology currently referred to as integrated DMOS (Double-diffused Metal-Oxide Semiconductor), two primary types of parasitic diodes are currently referred to as the Sub-Body-Drain diode (SubBD) and the Body-Drain diode (DBD). These diodes are intrinsic to the DMOS structure and play respective roles in the device's operation, particularly in handling voltage stress and current flow during switching operations.

The Body-Drain diode (DBD) is a parasitic diode between the body and the drain of the DMOS transistor due to the PN junction formed there. The DBD diode is forward-biased when the body is at a higher potential than the drain, allowing current to flow from the body to the drain. In power stages, the DBD provides a path for freewheeling currents during the off-state of the transistor. It has an impact in applications like class-D amplifiers and power converters, where inductive loads can cause current to continue flowing even when the transistor is turned off.

The sub-body-drain (SubBD) diode is similar to the BDB diode and it is associated with more complex DMOS structures, often influenced by additional doping or layout variations that affect the junction characteristics. The SubBD can provide additional pathways for current, potentially impacting the overall efficiency and thermal performance of the DMOS device. It has an impact in designs aiming to manage high-voltage stress and improve the reliability of the power stage by distributing voltage drops across multiple junctions.

Both BDB and SubBD diodes have an impact in DMOS device operations, in particular under various electrical stresses, facilitating to manage issues like reverse voltage protection and current continuity in inductive circuits. They also influence the overall efficiency and reliability of power stages, especially in applications that demand highspeed switching and minimal power loss.

Therefore, the abovementioned diodes are taken into account for the design of power electronics systems using integrated DMOS devices.

For instance, when currents are triggered deep forward conduction of DMOS diodes during DMOS reverse conduction, the ZSL circuit may become unbalanced due to the different charge storage in the SubBD diode and DBD diode of the high-side and low-side conducting DMOS transistors of the integrated circuit. During the reverse conduction phase, while high-side (HS) and low-side (LS) BDs are both conducting, also the SubBD junction of the LS DMOS is conducting. As the SubBD diode has a quite different transition time respect to BD diode, this can result in a difference on the stored charge and its release time.

LS and HS might have different dissipation conditions as a DMOS located at the corner of a semiconductor die can have a higher thermal resistance then one placed in the center, resulting in different working temperatures. Since diode conduction is highly dependent on temperature, an unbalance can exist.

Asymmetric packaging can further generate different electrical conditions (e.g., due to different bonding wire lengths or metallization).

Existing solutions are discussed in the following documents:
US 2019/238094 A1 discusses a switching circuit including a switching circuit stage configured to supply a load via filter networks; control circuitry is provided to control alternate switching sequences of transistors in the half-bridges of the switching circuit stage; a current flow line is provided between the output nodes of the half-bridges including an inductance between two switches; first and second capacitances are coupled with the output nodes of the half-bridges; the control circuitry switches first and second switches to the conductive state at intervals in the alternate switching sequences of the transistors in the half-bridges between switching the first pair of transistors to a non-conductive state and switching the second pair of transistors to a conductive state.

US 2019/0386615 A1 discusses an oscillator including a constant current generator configured to generate a constant current by maintaining a predetermined potential difference between both a first end and a second end of a resistor, and an oscillating element configured to output a clock signal corresponding to a charge and discharge cycle of a capacitor based on a bias current corresponding to the constant current.

US 2023/0208413 A1 discusses a comparator circuit including a first comparator configured to compare a voltage based on an input voltage with a first reference voltage, a charge/discharge portion configured to switch between charging and discharging of a capacitor based on an output of the first comparator, a second comparator configured to compare a voltage of the capacitor with a second reference voltage, and a control portion; the control portion is configured to, in a case where the voltage of the capacitor is larger than a predetermined value when the charge/discharge portion performs switching from the charging of the capacitor to the discharging thereof, supply a predetermined voltage instead of the voltage based on the input voltage to the first comparator until the voltage of the capacitor becomes smaller than the predetermined value so that the discharging of the capacitor is maintained by the charge/discharge portion.

US 2020/0321871 A1 discusses methods, apparatus, systems, and articles of manufacture are disclosed to improve power converter ON-time generation including a phase frequency detector to determine a phase difference between a first signal and a second signal, a first pulse generator to generate a first time signal at a second time, the first time signal associated with a first time delay based on the phase difference, and a second pulse generator coupled to the first pulse generator to generate a second time signal at a third time, the third time after the second time, the second pulse generator to obtain a digital word based on the phase difference at a first time, the first time before the second time and the third time, the second time signal associated with a second time delay based on the phase difference.

US 2011/0121797 A1 discusses a method of controlling a DC-DC converter is disclosed, which provides for compensation of the loop-delay caused by, for instance, delays in operation of the comparator.

### Object and summary

An object of one or more embodiments is to contribute in providing improved solution with reduced distortion and/or the charge stored in the diodes of the power stage. Such a solution facilitates countering output overshoot in case of unbalanced power stage circuitry.

According to one or more embodiments, that object can be achieved by means of a circuit having the features set forth in the claims that follow.

One or more embodiments may relate to a corresponding device (e.g. a class D audio power amplifier).

One or more embodiments may relate to a corresponding method.

The claims are an integral part of the technical teaching provided herein in respect of embodiments.

One or more embodiments relate to circuits and techniques to reduce unbalance (e.g., overshoot) in output signals of amplifiers using DMOS devices.

Taking into account the fact that diode conduction increases with temperature, increasing even more its recovery charge, one or more embodiments counter the effects produced by an unbalance in a ZSL circuit, thereby facilitating:
countering uncontrolled temperature increases due to regenerative effects, thereby maintaining the maximum power handled by the device;
maintaining a stable output commutation speed;
countering the degradation of DMOS performance due to output overshoot (e.g., rising above VCC); and
reducing unwanted output common mode signal generation.

One or more embodiments further relate to circuits and techniques to reduce charge storage in diodes (e.g., subBD and BDB) of the power stage.

One or more embodiments facilitate reducing power consumption (e.g., by around a 10%).

One or more embodiments facilitate extending a linear range of operation of a ZSL circuit driver (e.g., by reducing a minimum duty cycle available).

### Brief description of the several views of the drawings

One or more embodiments will now be described, by way of example only, with reference to the annexed figures, wherein:
Figure 1 is an exemplary block diagram of a switching circuit such as a switching amplifier;
Figure 2 is a circuit diagram exemplary of embodiments;
Figures 2A, 2B and 2C are diagrams exemplary of principles underlying one or more embodiments;
Figure 3 includes portions indicated a) to g) which are exemplary of certain signals which may occur in embodiments;
Figure 4 is a diagram exemplary of principles underlying one or more embodiments;
Figure 5 comprises portions indicated a) to g) which are exemplary of certain signals which may occur in embodiments;
Figure 6 is a diagram exemplary of a circuit operating according to the method exemplified herein;
Figure 7 is a diagram exemplary of a possible operation mode of one or more embodiments;
Figure 8 includes portions indicated a) to i) which are exemplary of certain signals which may occur in embodiments;
Figure 9 includes portions indicated a) to m) which are exemplary of certain signals which may occur in embodiments;
Figure 10 is a diagram exemplary of principles underlying one or more embodiments;
Figure 11 is a diagram exemplary of a circuit according to one or more embodiments, and
Figure 12 is a diagram exemplary of an alternative circuit according to one or more embodiments;
Figures 13 and 14 are diagrams exemplary of certain signals which may occur in embodiments.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description of exemplary embodiments

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment. Moreover, particular conformations, structures, or characteristics may be combined in any adequate way in one or more embodiments.

The references used herein are provided merely for convenience and hence do not define the extent of protection or the scope of the embodiments.

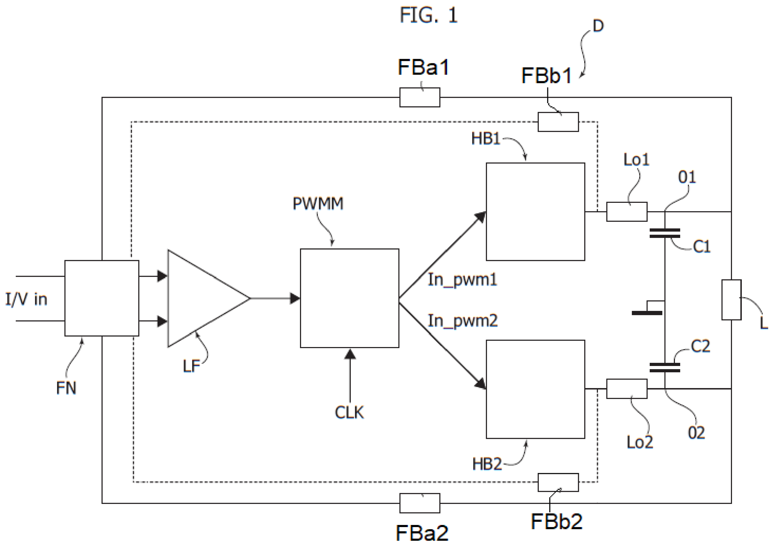

A first exemplary method, circuit and device as per the present disclosure is exemplified in Figures 1 to 7.

Figure 1 is exemplary block diagrams of a switching circuit such as a class D audio amplifier (for use, e.g., in a car audio system) including a switching bridge architecture.

In such a circuit a (voltage or current) input signal I/V in is applied (e.g., via a feedback network FN) to a loop filter LF which facilitates system stability while negative feedback (as implemented at FN) is intended to improve the amplitude and the frequency linearity.

As exemplified in Figure 1, a set of feedback branches FBa1, FBa2, FBb1, FBb2 are coupled to an output load L and to the feedback network FN to facilitate application of such negative feedback.

The output from the loop filter LF is fed to a PWM (Pulse Width Modulation) modulator PWMM clocked by a clock signal CLK. The modulator PWMM generates a two-level signal whose average value is proportional to the input signal I/V in, with a (fixed frequency) carrier defined by the clock signal CLK.

Two half bridge circuits HB1, HB2 - driven by the modulator PWMM via two signals In_pwm1, In_pvm2 - provide a PWM-modulated power signal across an LC output filter network comprising, e.g. respective inductances Lo1, Lo2 and capacitances C1, C2 in a mirror-symmetrical configuration.

In a class D bridge circuit as considered herein the signals In_pwm1 and In_pwm2 (and, consequently the outputs from the half bridges HB1, HB2) will have opposed phases (namely 180° phase shift): that is, either one of the signals In_pwm1 and In_pwm2 is a "negated" replica of the other.

An amplified version of the input signal I/V in will thus become available at a load L coupled across a first node O1 between the inductance Lo1 and the capacitance C1 and a second node O2 between the inductance Lo2 and the capacitance C2.

The circuit arrangement exemplified in Figure 1 is otherwise conventional in the art, thus making it unnecessary to provide a more detailed description herein.

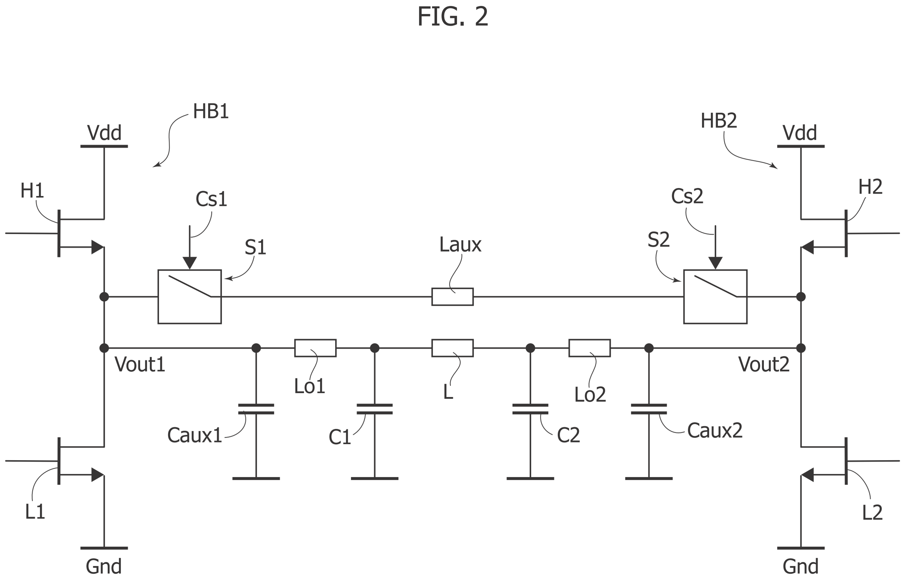

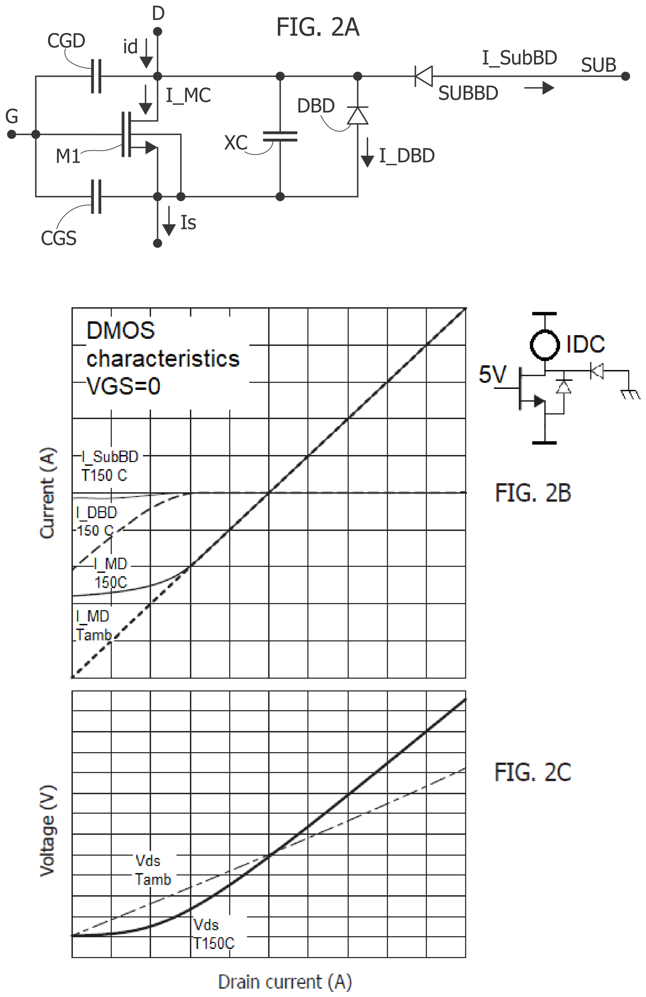

By referring, for instance, to the representation of HB1 and HB2 in Figure 2 (discussed later) one may note that, e.g., a 1→0 transition in In_pwm1 may turn off a high-side transistor H1. In order to avoid a cross-conduction with the corresponding low-side transistor L1, the low-side transistor L1 is turned on (only) after a dead time Dt1.

Due to the direction of current flow, the electromotive force of Lo1 may bring autonomously the output towards ground even though the low-side transistor L1 has not been turned on yet. As a result, the output is "clamped" by the body diode associated with L1 to a voltage slightly lower than the ground level.

Once L1 is turned on (after the dead time Dt1), the signal Vout1 from the half bridge HB1 reaches a voltage (under the ground level) given by lout1*Rds(on)H1 where Iout1 denotes the output current and Rds (on)H1 denotes the drain-source "on" resistance of the that transistor, namely H1 (e.g. a MOSFET transistor).

When In_pwm1 returns to the high-level (0-1), L1 is turned off and the associated body diode becomes again conductive.

Then H1 is again turned on (after a dead time Dt2) and the output will reach the supply voltage Vdd only as a result of H1 having discharged (completely) the "recovery stored charge" Qrr of the body diode of L1. This may give rise to current peaks in H1 largely in excess of Iout1, with associated Vout1 voltage overshoot due to package bonding-leads stray inductance.

The same remarks apply in a complementary way to the half bridge HB2.

A significant contribution to power dissipation in conventional arrangements as exemplified in the foregoing is the transition where the transistor which is in the process of being activated discharges the charge stored in the body diode. If the transition is a fast one, such a current may be appreciably higher than Iout. This leads to a correspondingly high power dissipation insofar as the drain-source voltage Vds is nearly equal to Vdd (the supply voltage of the two half bridges HB1, HB2 - see, e.g., Figure 2).

If one considers that the two half bridges HB1, HB2 may switch simultaneously, such a critical transition may take place likewise simultaneously with a correspondingly high current flow.

One or more embodiments facilitate providing a circuit suited for use, e.g. in a class D audio amplifier of the monolithic type having high switching frequency with the capability of reducing the amount of power dissipated as a result of switching (e.g., due to the critical transitions discussed previously) while improving linearity.

One or more embodiments also facilitate reducing the number of components which may be used for that purpose.

Figure 2 is exemplary of a general circuit layout in one or more embodiments. In Figure 2, the half bridges HB1, HB2 (to which the drive signals In_pwm1, Im_pwm2 are applied) are schematically represented as including respective "high side" and "low side" power transistors (e.g. power MOS transistors) H1, L1 (half-bridge HB1) and H2, L2 (half-bridge HB2) with respective intermediate nodes at which voltages Vout1, Vout2 are present.

These nodes (hereinafter, for brevity, Voutl, Vout2) are shown having the load L arranged therebetween with the low-pass LC filters Lo1, C1 (half-bridge HB1) and Lo2, C2 (half-bridge HB2) also shown.

It will be otherwise appreciated that the load L (and possibly the LC filter networks) may be a distinct element from the embodiments.

The two nodes Vout1, Vout2 will hereinafter be referred to as the "output" nodes (of the half bridges HB1, HB2) even though, strictly speaking, they do not represent the output nodes O1, O2 of the device D (see, e.g., Figure 1) having the load L coupled therebetween.

According to one or more embodiments, an electrical line is provided linking the "output" nodes in HB1 and HB2 between the high-side transistor H1, H2 and the low-side transistor L1, L2, that is the nodes/lines where the signals Vout1 and Vout2 occur.

The line between these nodes (for the sake of brevity, these two nodes will be identified in the following simply as Vout1 and Vout2) comprises an inductance Laux and two switches S1, S2. These may be controlled by respective signals (e.g. Cs1, Cs2) as discussed in the following.

The opposed terminals of Laux are coupled to S1 and S2; that is, Laux is set between S1 and S2. Consequently, the switch S1 will control coupling of the inductance Laux with the output Vout1 (half bridge HB1) and the switch S2 will control coupling of the inductance Laux with the output Vout2 (half bridge HB2).

The representation of Figure 2 also includes two further capacitances Caux1, Caux2 between the outputs Voutl, Vout2 respectively and ground.

In one or more embodiments, the capacitances Caux1, Caux2 can be provided (at least in part) by the parasitic capacitances of the transistors H1, L1 (Caux1) and H2, L2 (Caux2), in particular when using transistors of the DMOS kind.

As exemplified in Figure 2A, a DMOS macro-model which can be used to simulate the behavior of power MOSFET transistors such as Double-diffused Metal-Oxide-Semiconductor (DMOS) transistors, comprises:
a gate-source capacitive element Cgs for determining switching behavior and transient response;
a drain-source capacitive element XC, which contributes to the parasitic effects in the device, influencing high-frequency response and switching losses;
body effect diodes DBD, subBD, wherein the threshold voltage is influenced by the potential difference between the body (or substrate) SUB and the source terminal S.

Figures 2B and 2C depict characteristic curves of operation of a silicon DMOS.

As exemplified in Figures 2B and 2C, the DC behavior of a DMOS device (e.g., having a drain-source voltage about 5V), can be modelled in a manner analogous to that of an ideal switch having almost all of its current I_MC flowing in the MOS channel when the value of such current is positive (1^{st} quadrant of the characteristic). Conversely, when the current is negative (3^{rd} quadrant) such a modelling is no longer applicable as diode currents I_DBD and I_subBD can become non-negligible, in particular at high temperature.

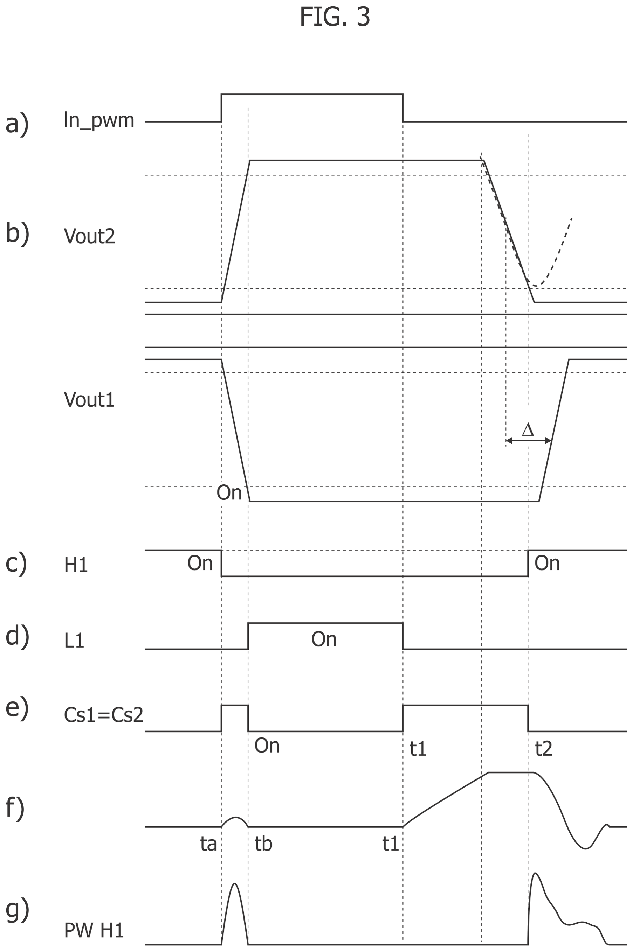

The diagrams in Figure 3 are exemplary of a possible time behavior of various signals in a ZSL circuit (per se known) where the presence of the aforementioned diode asymmetries is highlighted, assuming (as it may reasonably be the case) complementary PWM-modulated behaviors of In_pwm1 and In_pwm2 (generally labeled In_pwm in portion a of Figure 3).

In Figure 3:
in portion b), the behavior of the signal Vout2 is shown: the signal Vout1 will exhibit the same qualitative behavior in a complementary manner, that is, with Vout1 "low" when Vout2 is "high" and Vout2 "low" when Vout1 is "high", save from the fact that the rising front of Out1 is delayed by Δ respect to the falling front of Out2 as a consequence of the aforementioned body-diode asymmetries;
portions c) and d) portray the on and off conditions of the low-side and high-side transistors (L1 and H1, respectively) in the half bridge HB1;
portion e) portrays possible control signals Cs1=Cs2 applied to the switches S1 and S2, by assuming that an "On" value corresponds to the associated switch being made conductive;
portion f) exemplifies a possible time behavior of the current ILaux through the auxiliary inductance Laux, and
portion g) represents the power of DMOS H1 as the product of the voltage times the current flowing in high-side transistor H1 (due to body effects).

As exemplified in Figure 3, at time instant t1 signal Vout1 is at the "low" logic value and the circuit is configured to drive it towards the "high" logic state with a certain delay Δ with respect to a time instant in which corresponding signal Vout2 is driven low.

In a conventional solution, a control circuit manages the transition at time t1 by switching off L1 and H2 DMOS transistors trough respective drivers while concurrently switching ON the auxiliary control, resulting in a conduction from Vout2 "high" to Vout1 trough the auxiliary inductance Laux.

As exemplified in Figure 3, at time t2 when signal Vout2 has switched to the "low" logic value, conventional solutions would switch OFF the auxiliary Laux and switch ON high-side H1 and low-side L2, with Vout 1 still low.

As exemplified in Figure 3, in a ZSL ClassD circuit exemplified in Figures 2, the condition of having such front delay bigger than the rise/fall time would result in the hard switching (high current - high voltage) of the DMOS exemplified in Figure 2A, thereby forcing the transition of the delayed output signal (H1 in Fig 3), resulting in an appreciable power dissipation spike (PW H1 in Fig 3).

Inventors have observed that introducing the possibility to drive separately low-side transistors L1, L2 with respect to high-side transistor H2, H1, respectively while maintaining auxiliary control signals Cs1 and Cs2 facilitates reducing power dissipation. At least one further driver signal is therefore introduced, which can be named H1d, H2d, L1d and L2d.

As appreciable by those of skill in the art, at least in the audio-band frequency range, it may be possible to assume that amplifier input signals are varying slowly respect to PWM timings.

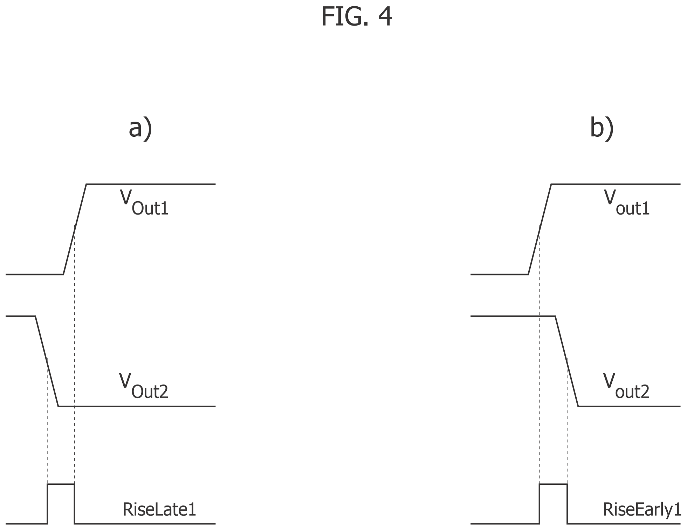

As exemplified herein, a method of operating a ZSL circuit comprises measuring the delay Δ, comprising generating additional control signals RiseLatel and RiseEarly1 based on output signals Vout1 and Vout2, as exemplified in Figure 4.

For instance:
a first additional control signal RiseLatel is indicative of a first rising edge of the first output signal Vout1 being late with respect to (that is, following the) falling edge of the second output signal Vout2; and
a second additional control signal RiseEarly1 is indicative of a first rising edge of the first output signal Vout1 arriving earlier with respect to (that is, preceding the) falling edge of the second output signal Vout2.

For instance, the additional control signals RiseLatel, RiseEarly1 can be viewed as PWM signals having a temporal width based on the delay Δ.

For the sake of simplicity, principles underlying one or more embodiments are discussed in the following mainly with respect to exemplary scenarios in which:
in portion a) of Figure 4, it is assumed that the delay Δ is present in the original ZSL circuit solely on one output signal, e.g., the one reverse conducting low (e.g., Vout1); as a consequence, a first additional control signals RiseLatel has a first logic value (e.g., "1" or "true") while a second additional control signal RiseEarly1 has a second logic value (e.g., "0" or "false").
in portion b) of Figure 4, it is assumed that the delay Δ is present in the original ZSL circuit solely on one output signal, e.g., the one reverse conducting low (e.g., Vout1 in Figure 4); as a consequence, when the first additional control signals RiseLate1 has the second logic value while a second additional control signal RiseEarly1 has a first logic value.

As exemplified herein, the method further comprises an integral control, generating a set of PWM signals Del1, Del 2 having the accumulated sum of the widths of one of the additional control signals minus the widths of the other additional control signal.

For instance, generating a first PWM signal Dell of the set of PWM signals Dell, Del2 comprises subtracting the width of the second additional control signal RiseLatel from the width of the first control signal RiseEarly1, while generating a second PWM signal Del2 of the set of PWM signals Dell, Del2 comprises subtracting the width of the first additional control signal RiseEarly1 from the width of the second control signal RiseLate1.

As exemplified herein, the method further comprises delaying the switching OFF of the high-side transistor (e.g., H2 of the second half-bridge HB2) by the width of the first PWM signal Del1 while also delaying switching OFF of the high-side transistor (e.g., H1 of the first half-bridge HB1) by the width of the second PWM signal Del2, providing a set of delay control signals H1d, H2d to the transistor driver.

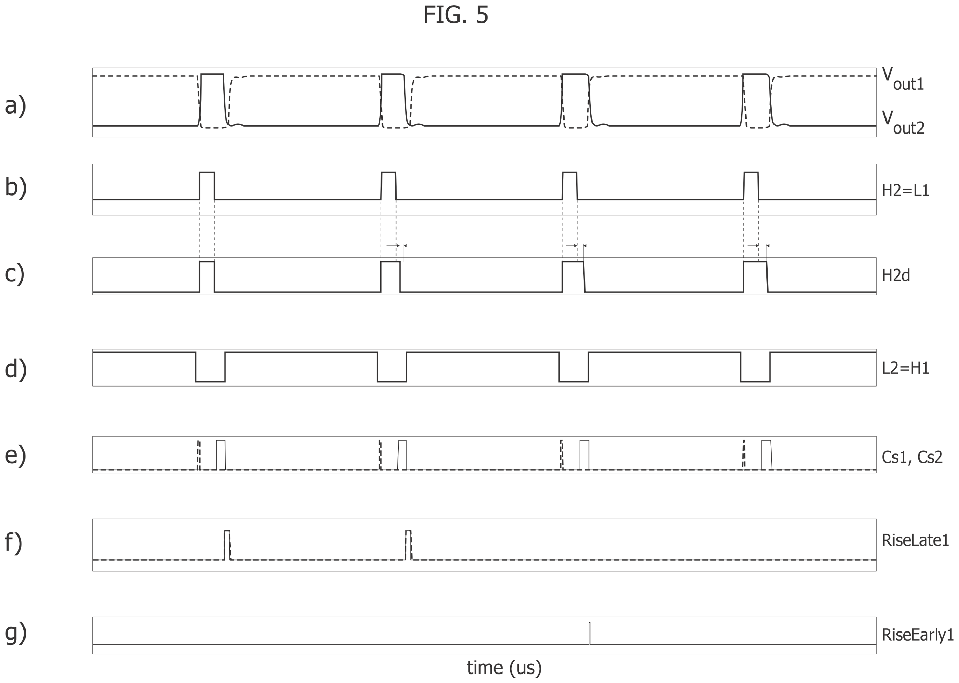

Figure 5 is a diagram exemplary of an evolution over time of signals suitable for use in one or more embodiments.

The diagrams in Figure 5 are exemplary of a possible time behavior of various signals in embodiments.

As exemplified in Figure 5:
in portion a), the behavior of the output signals Vou1, Vout2 is shown, with some differences being visible at the naked-eye in the transitions from "low" to "high" logic values (and vice versa) of the complementary signals;
portions b) portrays the on and off conditions of the low-side transistor L1 of the first half-bridge HB1 which is the same of the high-side transistor H2 of the second half bridge HB2;
portion c) represents the evolution over time of the second delay control signal H2d;
portion d) portrays the ON and OFF conditions of the low-side transistor L2 of the second half bridge HB2 and high-side transistor H1 of the first half bridge HB1;
portion e) portrays possible control signals Cs1=Cs2 applied to the switches S1 and S2, by assuming that an "On" value corresponds to the associated switch being made conductive, and
portions f) and g) represent the evolution over time of the first additional control signal RiseLatel and of the second additional control signal RiseEarly1, respectively.

An exemplary scenario portrayed in Figure 5 relates to a case in which, at the origin of the time axis, the current through the load of the arrangement exemplified in Figure 1 is suddenly increased, resulting in output signal Vout1 having rising front delay with respect to output Vout2, which conversely falls at lapse of the first PWM period.

As exemplified in Figure 5, thanks to the presence of the additional control signal H2d as driving signal for the high-side transistor H2 of the second half-bridge HB2, the latter remains turned ON while the Laux circuit is conducting. Such an arrangement forces output signal Out2 to remain at the logic value "high" until a specific value of the delay is reached which causes output signal Vout2 to synch back its turn-off with the turn-on of Vout1.

As exemplified herein, the method reaches a stable operating condition via successive approximations, exploiting a kind of iterative feedback to gradually adjust the delay by reducing the width of additional control signals RiseLate1, RiseEarly1. For instance, the correction at the Nth pulse comprises the delay measured and accumulated the previous pulses. In a reasonable scenario in which load current variation can be considered negligible with respect to a period Tpwm of the PWM signals, a stable delay adjustment is reached in the time of a few PWM cycles.

In a worst-case scenario in which the adjustment of the delay values presents a delay, so that the reaching a compensating value takes some time (e.g., due to additional control signals RiseLatel exceeding a threshold width), the driver of the high-side transistors HS1, HS2 can enter a safe driver operation mode in which the front edges of output signals Voutl, Vout2 slow down, e.g., by reducing the current for driving the HS gate to the high logic state. In such a safe mode operation, the slope dV/dt of the output voltage Vout can be controlled and limited even in case of fast current release from the DBD diode of the low side transistors LS1, LS2.

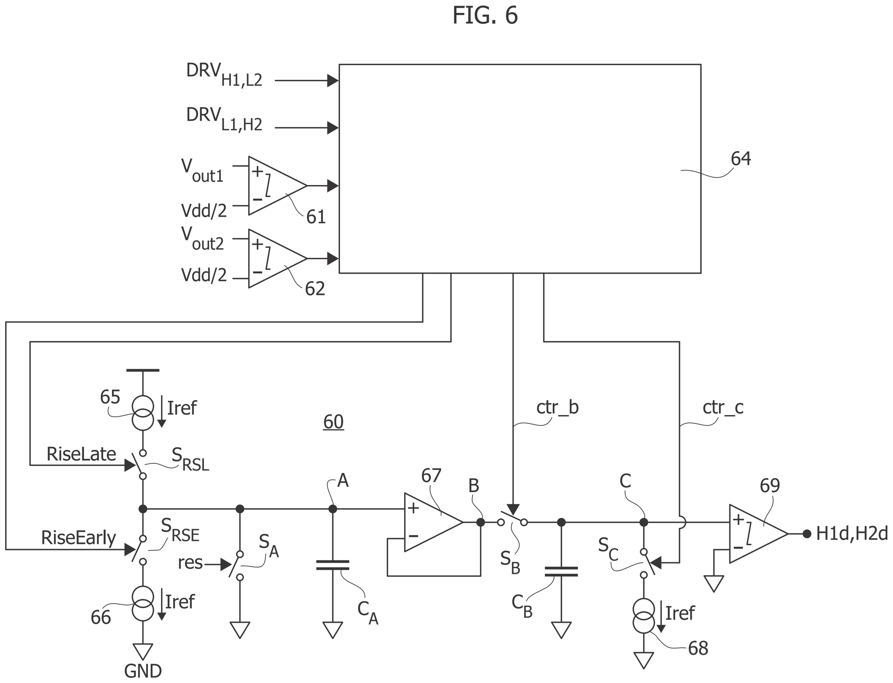

Figure 6 is a diagram exemplary of a circuit 60 operating according to the method as per the present disclosure.

As exemplified in Figure 6, the circuit 60 is based on a conversion from time (e.g., pulse width) to voltage, using capacitors as charge storage, current generators and switches, for instance.

As exemplified in Figure 6, the circuit 60 comprises:
a first comparator 61 having a first input node configured to be coupled to the first output node Vout1 of the first half-bridge HB1 (see, e.g., Figure 2) to receive the first output signal Vout1 therefrom, the first comparator 61 having a second input node configured to be coupled to a reference voltage level Vdd/2, e.g., equal to half the supply voltage Vdd of the half-bridge HB1; as exemplified in Figure 6, the first comparator 61 is configured to perform a comparison of the first output signal Vout1 and the reference voltage level Vdd/2, providing the result of the first comparison to a logic circuit block 64;
a second comparator 62 having a first input node configured to be coupled to the second output node Vout2 of the second half-bridge HB2 (see, e.g., Figure 2) to receive the second output signal Vout2 therefrom, the second comparator 62 having a second input node configured to be coupled to a reference voltage level Vdd/2, e.g., equal to half the supply voltage Vdd of the half-bridge HB2; as exemplified in Figure 6, the second comparator 62 is configured to perform a comparison of the second output signal Vout2 and the reference voltage level Vdd/2, providing the result of the second comparison to a logic circuit block 64;
the logic circuit block 64 coupled to the first comparator 61, the second comparator 62 to receive the comparison signals therefrom and further coupled to a set of switches S_{RSL1}, S_{RSE1}, S_{A}, S_{B}, S_{C} to provide a respective set of switch control signals RiseLate, RiseEarly, res, ctr_b, ctr_c, as discussed in the following;
reference current generators 65, 66, 68 coupled to respective switches S_{RSL1}, S_{RSE1}, S_{C} of the set of switches S_{RSL1}, S_{RSE1}, S_{A}, S_{B}, S_{C} and configured to provide reference currents Iref along a current flow line towards ground GND;
an operational amplifier stage 67, such as a buffer, having a first input node + coupled to an intermediate node A interposed among the switches S_{RSL}, R_{RSL}, S_{A} of the set of switches S_{RSL1}, S_{RSE1}, S_{A}, S_{B}, S_{C}, the operational amplifier 67 having a second input node - coupled to an output node B;
a first capacitive element C_{A} coupled to the intermediate node A and a second capacitive element C_{B} selectively couplable to the output node B of the amplifier 67 via the switch S_{B};
a third comparator 69 (e.g., a window comparator) having an input node coupled to a node C of the second capacitor C_{B} referred to ground GND and a second input node coupled to ground GND, the third comparator 69 configured to provide the additional control signals H1d, H2d to the drivers of the power stages H1, L2 of the half-bridge arrangements HB1, HB2.

As exemplified in Figure 6, among switches in the set of switches S_{RSL1}, S_{RSE1}, S_{A}, S_{B}, S_{C}:
the first switch S_{RSL}. is configured to selectively couple reference current generator 65 to node A based on control signal RiseLate received from the control logic 64;
second switch S_{RSE} is configured to selectively couple reference current generator 66 to node A based on control signal RiseEarly received from the control logic 64;
third switch S_{A} is configured to selectively couple node A to ground GND based on a reset control signal res (e.g., provided by control logic 64 or other control circuitry not visible in Figure 6 for the sake of simplicity);
fourth switch S_{B} is configured to selectively couple nodes B and C therebetween based on control signal ctr_b (e.g., at the rising edge of control signal H2) received from the control logic 64;
fifth switch S_{C} is configured to selectively couple node C to reference current generator 68 based on control signal ctr_c (e.g., at the falling edge of control signal H2) received from control logic 64.

As exemplified in Figure 5, a method of operating the circuit 60 comprises:
performing a comparison 61, 62 of at least one output signal Voutl, Vout2 from respective half-bridge circuits HB1, HB2 and a threshold value Vdd/2, obtaining at least one delay control signal RiseLate, RiseEarly as a result of the comparison(S);
converting to a voltage level the width of the part of the signal at a logic "high" value of the at least one delay control signal RiseLate, for instance by charging capacitor CA via one of the reference current generators 65, 66 which is coupled thereto as a result of the comparison;
converting to a voltage level the width of the part of the signal at a logic "high" value of the at least one delay control signal RiseEarly, for instance by discharging capacitor CA with the same reference current Iref.

As exemplified in Figure 6, the method further comprises:
transferring the voltage on the first capacitor CA to the second capacitor CB (e.g., via voltage buffer 67), and
- converting the voltage signal to a delay, e.g., again discharging the second capacitor CB using the same reference current Iref;
- applying the converted delay Δ to a falling edge/front of a respective drive signal (e.g., DRVH2, generating second additional control signal H2d signal or DRVH1, generating additional control signal H1d).

Therefore, thanks to the circuit 60 a delay Δ is introduced, in an iterative manner, in the turn-ON of H2 in function of the delay between Vout1 and Vout2, thereby finely synchronizing the signals and improving the overall performance of the ZSL power stage exemplified in Figure 1.

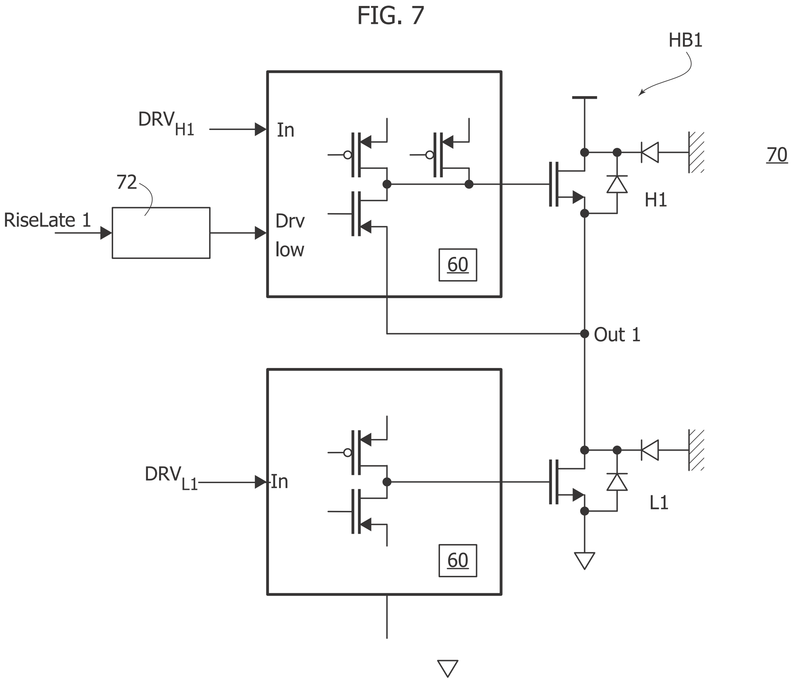

As exemplified in Figure 7, in order to implement a "safe driver" operating mode, the circuit 60 can be arranged in parallel to a filter circuit 72 configured to detect any abrupt variation of the time-distance among fronts of signals Voutl, Vout2 (e.g., above 10ns). For instance, the filter circuit 72 is coupled to driver-generating amplification circuitry 74 comprising a plurality of power stages. In response to the filter circuit 72 indicating that the delay among the signal fronts Voutl, Vout2 is greater than a threshold, a reduced number of power stages are activated for the driver-generating amplification circuitry 74, thereby reducing the drawbacks of the introduced hard-switching which can be hardly compensated in few iterations of the compensation method discussed in the foregoing.

As exemplified in Figure 7, the filtered signal from block 72 controls output stage activation (e.g., two-stages or more depending on the specific driver architecture), limiting the current available to drive the HS gate in conduction.

A second exemplary method, circuit and device as per the present disclosure is exemplified in Figures 1, 2, 2A, 2B, 2C and 8 to 13.

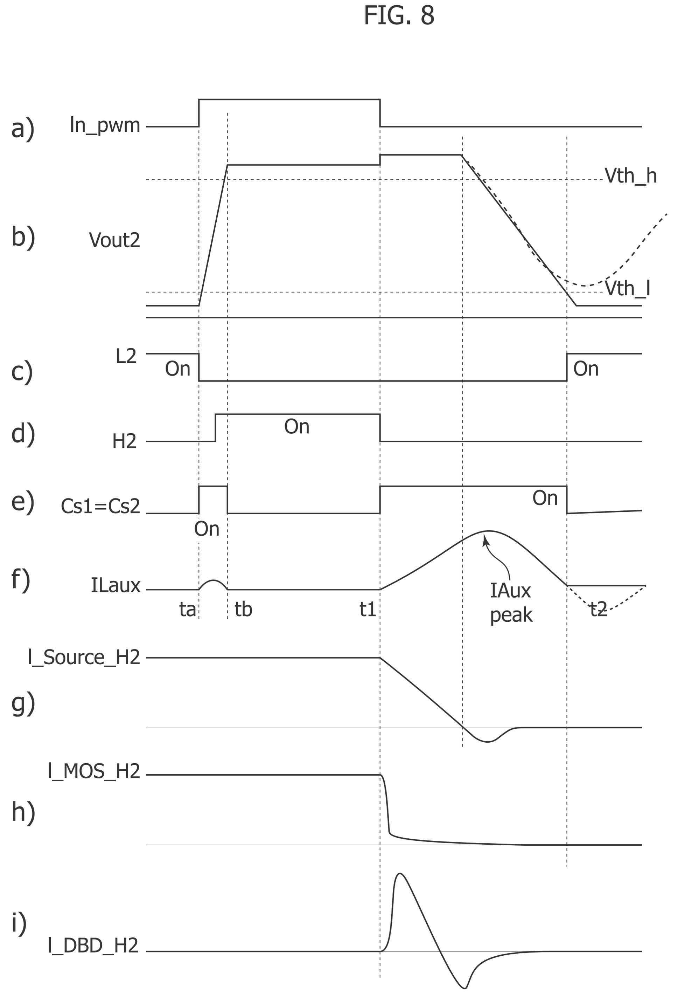

Figure 8 comprises diagrams of an evolution over time of signals suitable for use in one or more embodiments.

In the following one or more embodiments are discussed mainly with reference to a situation in which the previously-discussed delay is neglected for the sake of simplicity. Therefore, the following discussion mainly relates to exemplary scenarios in which the lack of synchronization of output signal fronts Voutl, Vout2 can be neglected, either because already compensated as discussed in the following or because negligible with respect to the other parasitic effects discussed in the following.

As exemplified in Figure 8, because of the DBD and subBD effects, the second output voltage Vout2 reaches a logic "high" value (e.g., at time instant tb) while a current I_MC is flowing through the high side HS2 of the second half-bridge HB2. In other words, the exemplary scenario represented in Figure 8 refers to a case in which the high-side transistor HS2 of the second half-bridge HB2 exemplified in Figure 2 is conducting in reverse mode (e.g., from time instant tb to time instant t1 exemplified in Figure 8).

As used herein, the term "hard switching" is currently designated an output transition starting with the switching OFF of one main reverse conducting DMOS, (in fig 8 between t1 and t2) that may occur in a ZSL or non-ZSL ClassD amplifier. Conversely, a transition starting with the switching OFF of a forward conducting DMOS (in fig 8 between ta and tb) is called "Soft switching".

Figure 8 depicts a waveform of a ZSL amplifier occurring when the current load is bigger than the ripple current, so that one commutation (the first one exemplified in the Figure, for instance) is relative to soft switching, and the next one is relative to hard switching.

In Figure 8:
in portion a), the evolution of driver signal In_pwm is represented; such a signal can be equal, e.g., to the driver In_pwm2 for the second high-side transistor H2 and in quadrature with the driver signal In_pwm1 for the first high-side transistor H1;
in portion b), the behavior of the signal Vout2 is shown;
portions c) and d) portray the on and off conditions of the second low-side and second high-side transistors (L2 and H2, respectively) in the second half bridge HB2;
portion e) portrays possible control signals Cs1=Cs2 applied to the switches S1 and S2 exemplified in Figure 1, by assuming that an "On" value corresponds to the associated switch being made conductive;
portion f) exemplifies a possible time behavior of the current ILaux through the auxiliary inductance Laux, and
portion g) represents an evolution over time of a current Is (e.g., see Figure 2A) flowing from (e.g., the source terminal of) the second high-side transistor H2 of the second half-bridge HB2;
portion h) represents a current I_Mc (see, e.g., Figure 2A) through the MOS channel of the second high-side transistor H2 of the second half-bridge HB2;
portion i) portrays an evolution over time of a diode current I_DBD (see, e.g., Figure 2A) through the diode-body-diode of the second high-side transistor H2 of the second half-bridge HB2.

As exemplified in Figures 2B and 8, current in steady state conditions results partitioned depending on temperature in three components: the one in the main MOS channel, the one in the DBD diode and the one in the SubBD diode (the latter is zero for an HS).

In the same time lapse, the transistors in the first half-bridge arrangement HB1 are in a complementary condition: a same current magnitude Is is coming out from the (e.g., source terminal of) the low-side transistor L1, which is conducting in reverse mode.

For the sake of simplicity one or more embodiments are discussed in the following mainly with reference to the second half-bridge arrangement HB2, being otherwise understood that one or more embodiments can apply to the first half-bridge arrangement HB1 mutatis mutandis.

As appreciable to those of skill in the art, a reverse conduction condition of the power transistors can be identified by the current sign and the output PWM voltage.

As exemplified in Figure 8, at time instant t1 the auxiliary switches S1, S2 are switched ON (see control signals Cs1=Cs2) while the high-side switch H2 is turned-OFF at the same time (drive signal H2). Even in a hypothetical case in which a very fast turn-on of the auxiliary switches S1, S2 can be contemplated, the auxiliary inductor Laux may represent a bottleneck insofar as its increase can hardly be instantaneous for a finite voltage applied. Therefore, the current mainly flows in the DBD diode of the high side transistor H2 since the threshold voltage Vgs is being switched OFF.

In case the device temperature is high enough (e.g., higher than room temperature) and the rising time Tdel_Main is equal to or greater than a reverse recovery time of a DBD diode, the scenario represented in Figure 8 could contemplate the possibility that the diode DBD is already conducting a positive current before time t1 even if gate-source voltage Vgs is above the threshold. In any case a DBD current increase will happen after t1, as exemplified in portion i) of Figure 8.

For the sake of simplicity, one or more embodiments are discussed primarily with respect to the ZSL circuit architecture exemplified in Figure 1, being otherwise understood that such an architecture is purely exemplary and in no-way limiting. One or more embodiments may apply to any ZSL circuit architecture mutatis mutandis.

As exemplified in Figure 2A, the charge stored in the diodes DBD, subBD of a DMOS device can vary with temperature. Moreover, as exemplified in Figure 8, there can be other dependencies from: the exact timing of switching off and on of the switches, the inductance value Laux and output capacitance value Cout.

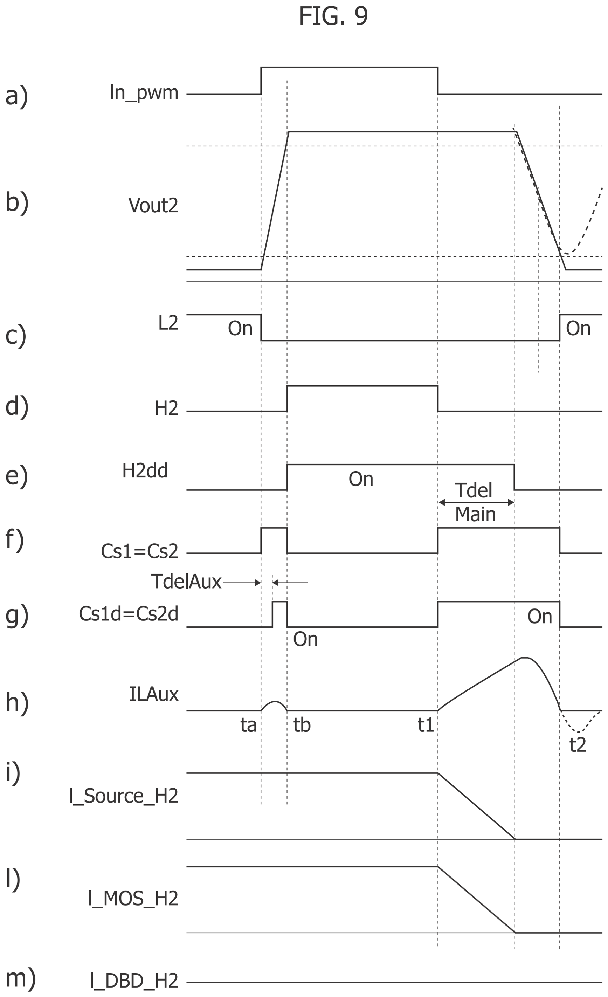

Inventors have observed that by de-coupling control signals Cs1 and H2 and controlling their timing, it can be possible to reduce DBD conduction of H2 that is the current I_DBD_H2 represented in portion i) of Figure 8. Such an exemplary scenario is represented in Figure 9, where:
in portion a), the evolution of driver signal In_pwm is represented; such a signal can be equal, e.g., to the driver In_pwm2 for the second high-side transistor H2 and in quadrature with the driver signal In_pwm1 for the first high-side transistor H1;
in portion b), the behavior of the signal Vout2 is shown;
portions c) and d) portray the on and off conditions of the second low-side and second high-side transistors (L2 and H2, respectively) in the second half bridge HB2;
portion e) portrays a further control signal H2dd which can be provided to the (e.g., second) high side transistor control node to reduce the charge Qrr stored in body diodes and relative effects, as discussed in the following;
portion f) represents possible auxiliary control signals Cs1=Cs2 according to the prior art,
portion g) shows modified auxiliary control signals Cs1d=Cs2d configured to be applied to the switches S1 and S2 exemplified in Figure 1, by assuming that an "On" value corresponds to the associated switch being made conductive;
portion h) exemplifies a possible time behavior of the current ILaux through the auxiliary inductance Laux, and
portion i) represents an evolution over time of a current I_source_H2 flowing from (e.g., the source terminal of) the second high-side transistor H2 of the second half-bridge HB2;
portion 1) represents a current I_MOS_H2 through the MOS channel of the second high-side transistor H2 of the second half-bridge HB2;
portion m) portrays an evolution over time of a diode current I_DBD_H2 through the diode-body-diode of the second high-side transistor H2 of the second half-bridge HB2.

As exemplified in Figure 9, a method of reducing a current flowing in the body diode comprises:
providing separate control signals CS1d, CS2d for the auxiliary switches S1, s2 and further control signals H1dd, H2dd for the high-side transistors H1, H2;
in response to a high-side transistor H1, H2 entering a reverse conduction state, introducing a delay in the turn-off of the high-side transistor H1, H2, for instance by introducing a delay in Tdel as exemplified in portion f) of Figure 9; such a delay with respect to control signal Cs1, Cs2 for the auxiliary switches S1, S2 facilitates countering the increase of DBD current, as exemplified in portion m) of Figure 9.

As exemplified in Figure 9, the method further comprises selecting the value of the delay Tdel to be equal to the time interval it takes for the auxiliary current ILaux flowing through the auxiliary inductance Laux to reach a same intensity of the current of the main inductor L exemplified in Figures 1 and 2 (e.g., reaching optimal pre-charging condition).

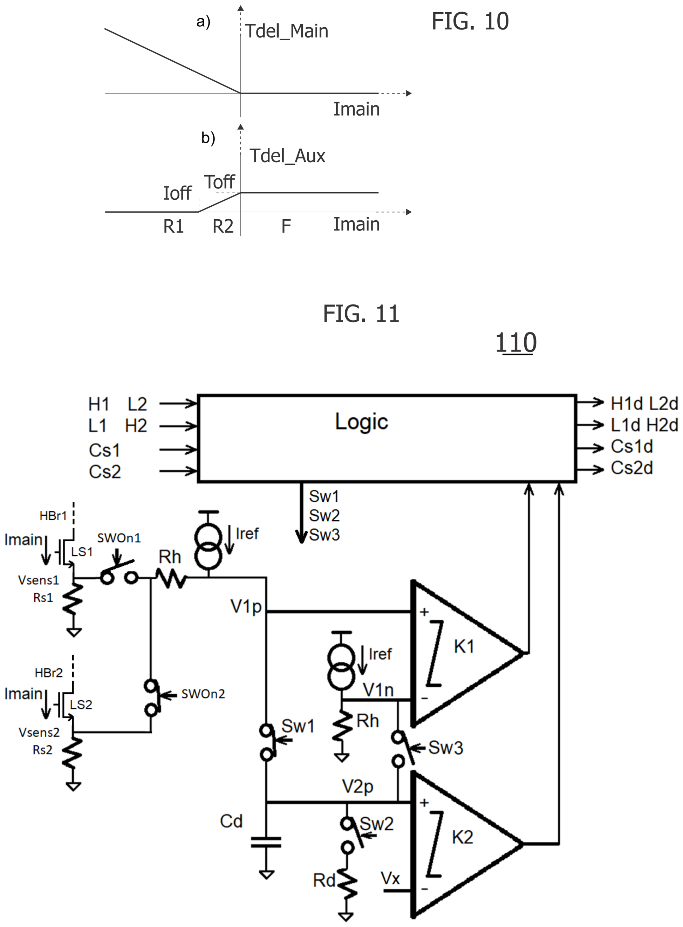

Portion a) of Figure 10 exemplifies a plot (intensity of source current Is on the abscissa scale in Ampere units, Main power delay time Tdel_main on ordinate scale in second units) of the delay to apply to "main" control signal (e.g., driver of the second transistor H2) to obtain the further control signals H1dd, H2dd.

For the sake of simplicity, one or more embodiments are discussed herein with respect to an exemplary case in which it is assumed that the auxiliary gate switching time (e.g., TgAux) is equal to the switching time of the DMOS gate of the transistor (e.g., TgMain=TgAux).

In such an exemplary case, the time delay Tdel_Main exemplified in Figure 10 can be expressed as: $Tdel_Main = - Is * Laux / \left(Vdd-2*Vdrop\right)$ where:
Is represents the output current in the high-side power (e.g., H2) just before t1 (sign minus because in reverse),
Laux is the value of the inductance of the auxiliary inductance Laux,
Vdd is the supply voltage, and
Vdrop is the voltage drop across one auxiliary switch (composed usually by 2 DMOS) and one main DMOS turned ON and having a current flow Iload therethrough.

As exemplified in Figure 9 and left side (negative abscissa) of Figure 10, in an exemplary scenario in which the current Is coming from the output, before time instant t1, enters the second high-side transistor H2 and the first low-side transistor L1 in reverse mode (with the transistor turned on by having a voltage Vgs applied to the control nodes). In such an exemplary scenario, if the on-resistance of the power stages H2, L1 is adequate, at low temperature the current Is flows (mainly) through the MOS channel of the respective transistors.

According to the invention, after time instant t1, the gate-source of the transistors H2, L1 is kept "high" until the current in the auxiliary switches S1, S2 of the circuit exemplified in Figure 2 increases, reaching the output value Iout. In response to reaching such a condition, after a delay time TdelMain from time instance t1, the current in the MOS channel becomes almost negligible. In response to the gate-source voltage Vgs being removed (therefore, with the transistors switched off), no current affects the DBD and SubBD diodes. In such an exemplary scenario, in case of high temperatures that might introduce a positive DBD current before time instance t1, such an increase of DBD current is countered after time instance t1. Therefore, at the end of the method operations, DMOS reverse recovery is reduced to a minimum.

Portion b) of Figure 10 is a plot (source current intensity Is on abscissa scale in Ampere units, auxiliary delay Tdel_aux on ordinate scale in second units) which illustrates how to determine the delay to introduce to provide additional auxiliary control signals Csld, Cs2d starting from control signals Cs1, Cs2 and taking into account a more refined scenario.

As exemplified in the right side (positive abscissa) of Figure 10, in response to the high-side switch entering a forward-conductive stage (as exemplified in Figure 8, corresponding to the time instant ta, that is at the soft switching transition): the output switching is driven by the main current right after switching OFF L2 and H1. Therefore, the auxiliary switches S1, S2 are switched ON after a time lapse sufficient for the switching OFF of the main DMOS H2 in order to counter spurious conduction from L2 and H1 through auxiliary switches S1, S2, which would result in spurious dissipation.

As exemplified in Figure 9, during time interval ta-tb, the method comprises delaying the auxiliary control signals Cs1, Cs2 to be applied to auxiliary switches S1, S2 of a quantity TdelAux = Toff that is selected in order to avoid auxiliary cross conduction.

According to the original ZSL circuit, during the time interval ta-tb, the switching OFF of L1 and H1 is done maintaining a zero delay after time instant ta, and the switching ON of H2 and L1 starts at tb, corresponding to Vout2 having raised up sufficiently (or Vout1 has fallen down sufficiently) for the respective comparator to commutate.

For instance, in order to facilitate a smooth transition among the case of high forward current (right side of Fig 10, named F) to high reverse current (left side of Fig. 10, named R1), the "intermediate" case (named R2) is managed according to the following:
in a first exemplary case exemplified in the left portion a) of Figure 10 in which the current flowing from the source Is of the high-side H2 is negative before switching a power off, a delay Tdel_main is applied to the switching off of the main (which can be expressed as Tdel_Main = -Is . Laux / (Vdd-2*Vdrop) while an auxiliary delay Tdel_aux exemplified in left portion b) of Figure 10 can be reduced from Toff proportionally to the current till being zero.

In such an exemplary scenario, the auxiliary delay Tdel_aux can be expressed as: $Tdel_Aux = Max \left[0,Toff+Imain. Laux/\left(Vdd-2*Vdrop\right)\right.$ where Imain is negative.

The value of IMain current at which Toff + Imain . Laux /(Vdd-2*Vdrop)=0 is called Ioff. It follows that: $abs \left(Ioff\right) = Toff . \left.\left(\left(VCC-2Vdrop\right)/Laux\right)\right)$

For instance, considering a different scenario in which the source current is positive, the main delay is reduced to zero (e.g., Tdel_Main = 0) while an auxiliary delay Tdel_aux can be applied to the auxiliary control signals Cs1, Cs2, with the auxiliary delay that can be equal to a given value Toff (e.g., which can be increased as much as the main driver delay Tdel_main eventually increases with the current).

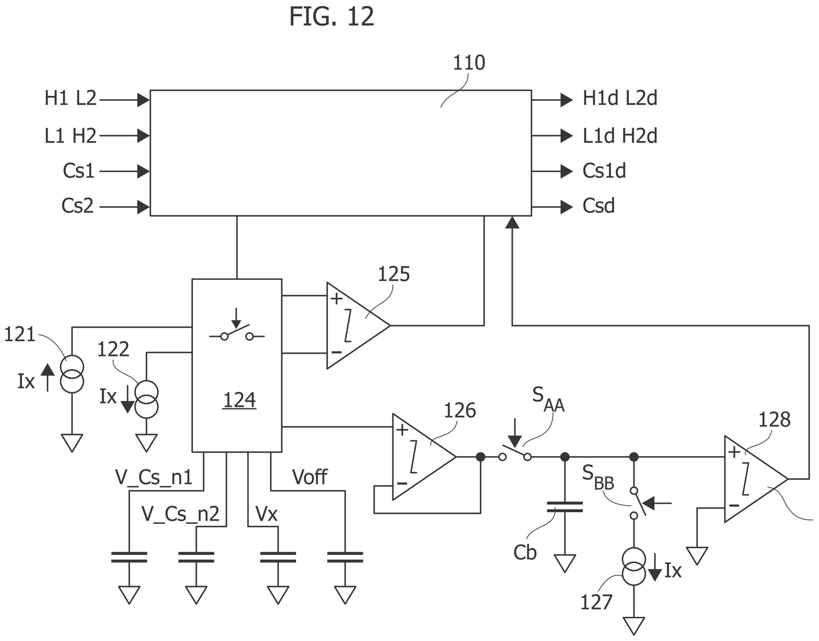

Figures 11 and 12 are diagrams exemplary of one or more circuits configured to implement the control method discussed above with reference to Figures 8 to 10.

For the sake of simplicity one or more embodiments are discussed in the following mainly with reference to a circuit for providing separate C2s and additional H2dd control signals for the second auxiliary switch S2 and the second high-side transistor H2, being otherwise understood that such an example is purely exemplary and in no way limiting as the circuit 110 can be used mutatis mutandis for any other transistor in the half-bridge arrangement.

As exemplified in Figure 11, a circuit 110 comprises:
a set of current sensing arrangements configured to measure the respective voltage drops Vsens1, Vsens2 across respective low-side DMOS transistors LS1, LS2 of the half-bridges HB1, HB2 (e.g., by sensing the voltage at the metal connection at Source terminal, like figure 11, or on its Drain to Source voltage on Ron during DMOS channel conduction as exemplified with resistive elements Rs1, Rs2 of equal value Rs;
a reference resistance Rh coupled to a reference current generator 114 configured to provide reference current Iref, the reference resistance Rh being selectively couplable (e.g., via switches Swon1, Swon2) to the sensing nodes Vsens1, Vsens2; quantitatively, Rh >> Rs, Iref << Max(Imain).

For instance, the value of Iref and Rh is related to the absolute value of Ioff defined above, described in section b of Fig 10, by the following equation: $Iref ⋅ Rh = \left|Ioff\right| ⋅ Rs = Vref$

As exemplified herein, switches SWOn1 and SWOn2 are configured to couple each respective sensing arrangement to the respective low-side DMOS LS1, LS2 when the latter is conducting (e.g., while the current in reverse conduction is passing mainly through the MOS channel during conduction). For instance, switches Swon1, Swon2 are configured to be driven based on output PWM sign (e.g., turn ON Swon1 when Out1is "low", turn ON Swon2 when Out2 is "low"). Given a certain load current, and a certain duty cycle D, each PWM cycle, the amplifier exemplified in Figure 2 presents a first conductive diagonal path among DMOS transistors (e.g., among first low side L1 and second high side H2) for a time approximatively Tpwm*D and a second conductive diagonal path among DMOS transistors (e.g., among first high-side H1 and second low-side L2) for a time Tpwm*(1-D).

As exemplified in Figure 11, the circuit 110 further comprises:
a first comparator circuit 112 having a first comparator input node coupled to the voltage node V1p and a second comparator input node coupled to voltage node V1n interposed a further reference current generator 114 and a replica of reference resistance Rh, thereby providing reference voltage level Vref at the second comparator node; the first comparator circuit 112 is further configured to provide at a comparator output node K1 the difference among signals at input signals;
a second comparator circuit 114 having respective comparator input nodes coupled to a second voltage node V2p and to V2n = Vx, where Vx is a small fixed voltage threshold, e.g., equal to a fraction of Vref; the second comparator circuit 114 being further configured to provide at a comparator output node K2 the difference among input nodes V2p, V2n.

As exemplified in Figure 11, the voltage node V1p is selectively couplable, via first switch Sw1 to a capacitive element Cd referred to ground GND. The voltage node V2p is coupled to the capacitive element Cd and is selectively couplable, via second switch Sw2, to a resistive element Rd referred to ground GND. For instance, a third switch Sw3 is configured to selectively couple the voltage node V1n at the second input node of the first comparator 112 to the voltage node V2p at the first input node of the second comparator 114.

As exemplified in Figure 11, the circuit 110 further comprises a logic circuit block 110 coupled to the high-side switch driver H2, to the auxiliary switch driver Cs2, and to comparators 112, 114, the logic circuit block 110 configured to apply respective delays Tdel_main, Tdel_aux based on the received output signals from comparators 112, 114, thereby providing separate Csld and additional H2dd control signals to the circuit exemplified in Figure 2.

A method of operating the circuit 110 exemplified in Figure 11 comprises:
sensing the (e.g., source) current Is from low-side transistors L1, L2 by measuring the respective voltage drop Vs1, Vs2 on the respective sense resistance Rs1, Rs2 (representing a metal connection at source terminal, like figure 11 or on its drain-to-source voltage on-resistance Ron during VGS-ON DMOS channel conduction);

When switches Sw2 and Sw3 are open, and Swon1or Swon2 closed, shifting the value of the sense voltage (e.g., Vs1=Vs2=Vsens) by superimposing thereto, at node Vip, a reference current Iref << MAX |Imain| across the known resistor Rh; in an exemplary case in which Rs1Rs2=Rs, it is possible to implement a level shifter adding a small positive entering Iref on such known resistor Rh. The node voltages V1p and V1n can be expressed as: $\left(Imain+Iref\right) ⋅ Rs ≅ Imain ⋅ Rs = Vs 1 = Vs 2 = Vsens$ $Iref ⋅ Rh = \left|Ioff\right| ⋅ Rs = Vref$ $V 1 p = Imain ⋅ Rs + Iref ⋅ \left(Rh+Rs\right) ≅ Vsens + Vref$ $V 1 n = Iref ⋅ Rh = Vref$ where $Ioff = Toff ⋅ \left(\left(VCC-2Vdrop\right)/Laux\right)$

For instance, the method further comprises:
performing a first comparison via first comparator 112
where its input node difference can be expressed as: $V 1 p - V 1 n ≅ Vsens$

As a result, the first comparator 112 provides to the logic circuit 110 a signal indicative of the sign of the sensed current Is.

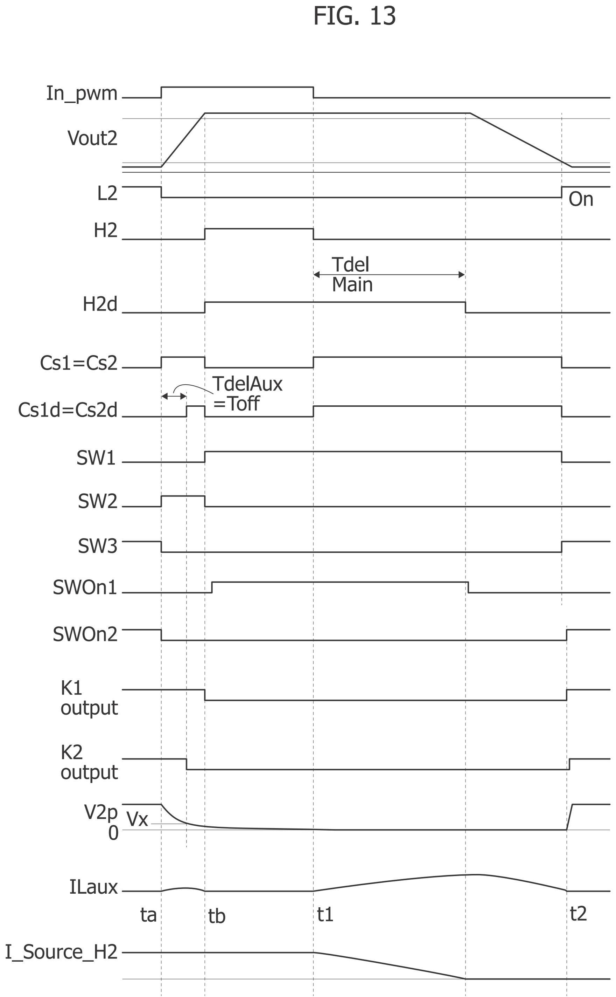

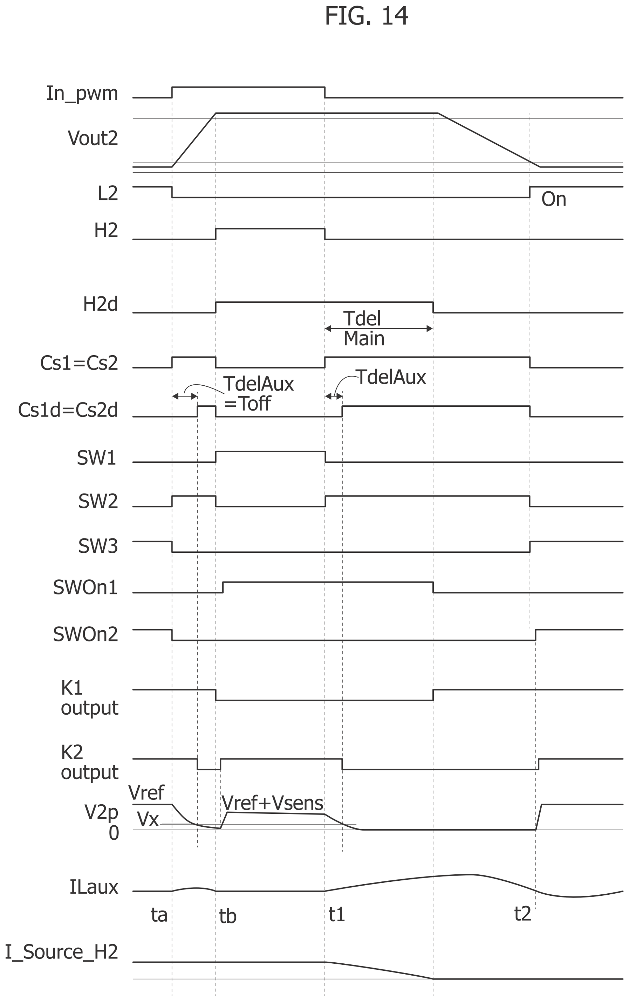

As exemplified in Figures 13 and 14:
in a first time interval tb-t1 (that is, just before the drive signal In_pwm switches from "high" to "low"):
switch SWon1 is turned ON (that is, closed), therefore coupling first sensing node Vsens1 to the input node V1p of the first comparator 112 trough RH;
in the exemplary scenario represented in Figure 13, an output K1 of the first comparator 112 is indicative of a negative sign of Vsens1 (DMOS reverse conduction) ;.in such a scenario, the logic circuit 110 is configured to provide control signals Sw1, Sw2, Sw3 to respective switches so that, neglecting the transitory effect of capacitor Cd charging, the first switch Sw1 is ON (that is, closed), the second switch Sw2 is OFF (that is, open) and the third switch is Sw3 OFF (that is, open); the differential input at the second comparator 114 is equal to the voltage Vref+Vsens -Vx, where Vsens is negative.
as exemplified in Figures 13 and 14, in a second time interval t2-ta (that is the time just before the drive signal In_pwm switches from "low" to "high"):
   switch SWon2 is turned ON (that is, closed) thereby coupling second sensing node Vsense2 to the input node V1p of the first comparator 112 trough RH;
   in the exemplary scenario represented in Figures 13 and 14, the output K1 of the first comparator 112 is indicative of a positive sign of Vsens2 (DMOS forward conducting); therefore, starting from t2 the logic circuit 110 is configured to provide control signals Sw1, Sw2, Sw3 to respective switches so that the first switch Sw1 is turned OFF (that is, open), the second switch Sw2 is turned OFF (that is, open) and the third switch Sw3 is turned ON (that is, closed); therefore, the differential input at the second comparator 114 is equal to the Vref-Vx.

As exemplified in Figure 13, at time t1 (in the exemplary case in which K1 is indicative of a negative current and drive signal In_pwm switches from high to low), if K2 output is equal to zero (because V2P=Vref+Vsens is lower than Vx), corresponding to figure 10 - R1 zone (high negative current):
the logic circuit 110 is configured to provide control signals Sw1 Sw2, Sw3 to respective switches so that the first switch Sw1 is ON (closed), the second switch Sw2 is OFF (that is, open) and the third switch Sw3 is OFF (that is, open);
auxiliary control signal Cs1 switches without any delay and the second high-side switch H2 remains turned ON;
as a result, the current in the auxiliary inductance Laux increases while concurrently the current in the main inductance L decreases, until Vsense reaches zero;
in response to Vsense reaching zero, the output K1 of the first comparator 112 switches;
in response to such a switch of K1, the second high-side H2 is switched off.

As exemplified in Figures 14, at time t1 (in the exemplary case in which K1 is negative and drive signal In_pwm switches from high to low), if K2 is positive (because V2P is greater than Vx), corresponding to figure 10 - R2 zone (small negative current):
the sensing current Isens, which is negative, is between Ioff and zero;
as a result, the second high-side H2 is kept turned ON while the control logic is configured to drive the first switch SW1 to be OFF (that is, open) and the second switch SW2 to be ON (that is, closed);
as a result, the discharge of second node V2p is triggered and proceeds until reaching a proper threshold Vx (e.g., R2 can be also a fixed current generator) is such to generate a delay Taux_del approximately proportional to a difference (Vref - |Vsens|) to be applied to the auxiliary controls (Cs1d and Cs2d) to be provided to the auxiliary circuitry in the ZSL circuit arrangement exemplified in Figure 2.

As exemplified in Figures 13 and 14, at time ta (in the exemplary case in which K1 is positive and drive signal In_pwm switches from high to low), K2 is positive and:
the control logic is configured to drive the first switch SW1 and the third switch SW3 to be turned OFF (that is, open) while the second switch SW2 is closed; as a result, the capacitor Cd (previously was charged at the max positive value Vref) is discharged through its network such to take a time Toff to make K2 commutate;
in response to the output signal commutating, the second high-side switch H2 is turned ON.

It is noted that, while one or more embodiments exemplified in Figure 11 have been discussed mainly with reference to the use of a current sensing on the power, the actuating switches are controlled based on the present value of the state variables.

Figure 12 is a diagram exemplary of an alternative circuit 120 to control the circuit 20 exemplified in Figure 2.

With respect to circuit 110 exemplified in Figure 11, the alternative circuit 120 is based on the hypothesis that amplifier input signals vary slower than PWM signals. Under such a hypothesis, the width of the auxiliary control signals Cs1, Cs2 can be used to provide an estimate Ix of the current Is flowing in DMOS power switches H1, H2 for next switching event.

For instance, when the power switches H1, H2 operate in reverse condition (also currently referred to as 3rd quadrant), the temporal width of auxiliary control signals Cs1, Cs2 is proportional to the time it takes the auxiliary inductance Laux to have the current flowing therethrough going from zero to a value ILaux=Is+Iboost+Tr. For instance, a time T_Cs in which the auxiliary control signal Cs2 is at a first logic level can be expressed as: $T _ Cs 1 = \left(Iout+Iboost\right) ⋅ Laux / Vd + Tr$ where:
Tr is a quantity dependent on output fall/rise time, which varies slightly with the output current.
Iboost is an additional current configured to compensate diode reverse recovery charge, and
Iout is the sum of the load current plus the ripple current which is dependent on the duty cycle.

As exemplified in Figure 12, the alternative circuit 120 comprises:
current generators 121, 122;
at least one sample-and-hold, S&H circuit 124 coupled to at least one current estimating node Ix and to a plurality of capacitive elements Cs_n-1, Cs_n-2, Cx, Coff configured to store respective voltages V _Cs_n-1, V_Cs_n-2, Vx, Voff as discussed in the following;
at least one comparator circuit 125 coupled to the S&H circuit 124 to perform at least one comparison of stored voltages V _Cs_n-1, V_Cs_n-2, Vx, Voff, as discussed in the following, and to provide the result(s) of the at least one comparison to the control logic circuit 110;
a buffer 126 coupled to the S&H circuit 125 to receive stored voltage values therefrom,
a buffer capacitive element Cb referred to ground GND and being selectively couplable to the output of the buffer 126 via switch Saa driven by a respective control signal from the control logic 110;
a further comparator circuit 128 having a first input node coupled to the buffer capacitive element Cb and a second input node coupled to ground GND, the further comparator circuit 128 configured to provide a delay signal Dell to the control logic 110 to be applied to auxiliary Cs2 and main H2 driver signals, providing separate Cs2d and delayed H2dd control signals as a result.

A common practice (per se known) for converting a time pulse-width into a voltage (and viceversa) comprises charging/discharging a known capacitor with a known current based on the pulse-width length.

In the following, a compact notation is used for the sake of simplicity, wherein:
VCs_n-1 = the time to voltage conversion of the (N-1)^{th} pulse width auxiliary control signal Cs2 (e.g., in Fig. 9 equal to tb-ta);
VCs_n-2 = the time to voltage conversion of the (N-2)^{th} pulse width of auxiliary control signal Cs2 (e.g., equal to t2-t1 of the previous pulse);
Voff is a pre-defined voltage, which is the time to voltage conversion of Cs1 when the current Is = Ioff
Vx, the time to voltage conversion of Tr equal to the Cs1 width when the current Is=0.

Inventors have observed that the sign of the current at the n-th pulse can be retrieved by pair-wise comparing VCs_n-2 and VCs_n-1.

In a first exemplary scenario in which the result of the comparison yields that VCs_n-2 is greater than VCs_n-1, then the current at the n^{th} pulse is estimated to be negative. As a result, the delay Tdel is applied to the driver signal H2 from time t1+, discharging a cap loaded at VCs_n-2 till reaching Vx, with the same current used to charge the same capacitors.

A buffer and a sample and hold can be used to store VCs_n-2 in the capacitor Cb, so that the process of loading the cap

Still considering the case in which VCs_n-2>VCs_n-1, if also the condition VCs_n-2 < Voff stands valid, this indicates that the regimen ta-tb exemplified in portion b) of Figure 10 applies. Therefore, also auxiliary control signal Cs2 is delayed by an auxiliary delay Tdel_aux via the control logic 110, providing separate auxiliary control signal Cs2d. In other words, the rising front of auxiliary control signal Cs2 is delayed by the time it takes to discharge, via a controlled current, the voltage Voff until equating voltage VCsn-2, in adherence with the expressions of Toff discussed in the foregoing.

In an alternative case in which VCs_n-2 <VCs_n-1, then the current at the n^{th} pulse is positive (corresponding to the regimen labelled as positive Is values after tb in portion b) of Figure 10). Therefore, a delay is applied to the auxiliary control signal but this time the delay is equal to the time it takes to completely discharge a capacitance loaded at Voff.

An advantage of the alternative circuit 120 exemplified in Figure 12 with respect to that of Figure 11 is the possibility to save current sensing circuitry, replacing it by time-to-voltage converting circuits.

One or more embodiments may employ both the method and circuit exemplified in Figures 1 to 7 and those exemplified in Figures 8 to 11 or 12 in order to compensate both the parasitic effects due to body drain diodes of switches S1, S2, H1, H2 produced using DMOS technology.

Example 1. In a first example, a circuit comprises:
a switching circuit stage comprising first HB1 and second HB2 half bridges comprising a first, high-side DMOS transistor H1, H2 and a second, low-side DMOS transistor L1, L2, the first half bridge and the second half bridge comprising respective output nodes Vout1, Vout2 between the high-side DMOS transistor and the low-side DMOS transistor therein, the output nodes configured for supplying an electrical load L via respective filter networks Lo1, C1; LO2, C2 between the output nodes Voutl, Vout2 and the load L;
- control circuitry 60 coupled to the switching circuit stage and configured to control Cs1, Cs2, RiseLate, RiseEarly switching sequences In_pwm of the high-side and low-side transistors in the first and second half bridges wherein a first pair of DMOS transistors comprising the high-side DMOS transistor in one of the half bridges and the low-side DMOS transistor in the other of the half bridges is switched to a non-conductive state, and a second pair of transistors comprising the high-side DMOS transistor in the other of the half bridges and the low-side DMOS transistor in the one of the half bridges is switched to a conductive state.

In the first example, the circuit comprises:
a current flow line between the output nodes in the first half bridge and the second half bridge, the current flow line comprising an inductance Laux having opposed terminals coupled to a first switch S1 and a second switch S2, the first switch and the second switch selectively switchable between a non-conductive state and at least one conductive state,
first and second capacitances Caux1, Caux2; CparH1, CparL1, CparH2, CparL2 coupled with the output nodes of the first half bridge and the second half bridge.

In the first example, the control circuitry is configured to switch H1d, H2d the first and second switches to the at least one conductive state at intervals ta, tb; t1, t2 in said switching sequences between switching the first pair of DMOS transistors H1, L2 to a non-conductive state and switching the second pair of DMOS transistors L1, H2 to a conductive state.

In the first example, the control circuitry is further configured to provide control signals H1d, H2d to switch at least one of said first and second switches based on at least one comparison signal indicative of a delay Δ among a first output signal at said first output node and a second output signal at said second output node.

Example 2. In a second example, the control circuitry comprises:
a set of comparators 61, 62 having respective first comparator input nodes coupled to output nodes of the first and second half-bridge circuits to receive the first and second output signals therefrom, the set of comparators having respective second comparator input nodes coupled to at least one reference voltage level Vdd/2 as well as respective comparator output nodes coupled to a logic circuit block to provide said at least one comparison signal indicative of the delay among the first output signal at said first output node and the second output signal at said second output node.

In the second example, the logic circuit block is coupled to the set of comparators to receive the at least one comparison signal therefrom, wherein the control circuitry further comprises a set of control switches S_{RSL1}, S_{RSE1}, S_{A}, S_{B}, S_{C} coupled to the logic circuit block to receive therefrom a respective set of switch control signals RiseLate, RiseEarly, res, ctr_b, ctr_c based on said at least one comparison signal.

Example 3. In a third example, the circuit further comprises:
a set of reference current generators 65, 66, 68 coupled to a first subset of control switches S_{RSL}, S_{RSE}, S_{C} in the set of control switches, the set of reference current generators configured to provide reference currents Iref along a current flow line towards ground GND;
an operational amplifier stage 67 having a first input node + coupled to an intermediate node A interposed first subset of control switches in the set of control switches, the operational amplifier arranged as a buffer having a second input node - coupled to the amplifier output node;
a first capacitive element C_{A} coupled to the intermediate node and a second capacitive element C_{B} selectively couplable to the amplifier output node via a respective control switch S_{B};
a third comparator 69 (e.g., a window comparator) having an input node coupled to one end C of the second capacitor referred to ground and a second input node coupled to ground, the third comparator configured to provide at least one additional control signal to at least one power stage of the half-bridge arrangement.

In the third example, the control circuitry is configured to:
performing a comparison 61, 62 of at least one of said output signal from respective half-bridge circuits and a threshold value Vdd/2, obtaining as a result of the comparison at least one first switch control signal RiseLate, RiseEarly in the set of set of switch control signals;
based on the at least one first switch control signal, charging S_{RSL} or discharging S_{RSE} the first capacitive element via a reference current provided by a reference current generator in the set of reference current generators;
transferring res, S_{A} the voltage on the first capacitive element to the second capacitive element via the operational amplifier stage, and
discharging ctr_b, S_{B} the second capacitor using said reference current Iref provided by a reference current generator in the set of reference current generators;
providing ctr_c, S_{C} to at least one power stage of the half-bridge arrangements the at least one additional control signal based on the signal at the one end of the second capacitor referred to ground.

Example 4. In a fourth example, the set of control switches comprises:
a first switch S_{RSL}. configured to selectively couple a first reference current generator in the set of reference current generators to said intermediate node based on a first control signal received from the control logic;
a second switch S_{RSE} configured to selectively couple a second reference current generator in the set of reference current generators to said intermediate node based on a second control signal RiseEarly received from the control logic;
a third switch S_{A} configured to selectively couple said intermediate node to ground based on a reset control signal *res;*
a fourth switch S_{B} configured to selectively couple amplifier output node and the signal at one end of the second capacitor therebetween based on control signal(s) *ctr_b* from the control logic;
a fifth switch S_{C} configured to selectively couple the one end of the second capacitor to the third reference current generator based on a further control signal received from control logic.

Example 5. In a fifth example, the circuit comprises a filter circuit 72 configured to detect variation of the time-distance among fronts of signals and coupled to driver-generating amplification circuitry 74 comprising a plurality of power stage. For instance, in response to the filter circuit 72 indicating that the delay among the signal fronts is greater than a threshold, a reduced number of power stages are activated for the driver-generating amplification circuitry.

Example 6. In a sixth example, the control circuitry comprises:
a set of current sensing arrangements Rs1, Rs2 configured to measure the respective voltage drops at respective sensing nodes Vsens1, Vsens2 across respective low-side DMOS transistors of the respective half-bridges;
a reference resistance Rh coupled to a reference current generator 114 configured to provide reference current, the reference resistance being selectively couplable Swon1, Swon2 to the respective sensing nodes of the set of current sensing arrangements;
a set of coupling switches configured to couple each respective sensing arrangement to the respective low-side DMOS during respective DMOS conduction;
a first comparator circuit 112 having a first comparator input node coupled to a first voltage node V1p and a second comparator input node coupled to a second voltage node V1n interposed a further reference current generator 114 and a replica of reference resistance, thereby providing reference voltage level Vref at the second comparator node; the first comparator circuit is further configured to provide at a comparator output node K1 the difference among its input signals, which is therefore equal to the sensing voltage Vsens;
a second comparator circuit having respective comparator input nodes coupled to a third voltage node V2p and ground, the second comparator circuit being further configured to provide at a comparator output node K2 the difference among its input nodes.

In the sixth example:
the first voltage node is selectively couplable, via a first control switch Sw1, to a capacitive element Cd referred to ground;
the third voltage node is coupled to the capacitive element and is selectively couplable, via a second control switch Sw2, to a resistive element Rd referred to ground, and
the second voltage node is selectively couplable, via a third control switch Sw3, to the third voltage node;
the control circuitry further comprises a logic circuit block 110 coupled to the high-side switch, to the auxiliary switch driver Cs2, and to first and second comparators, the logic circuit block configured to apply respective delays Tdel_main, Tdel_aux based on the received output signals from comparators 112, 114, thereby providing separate Csld and additional H2dd control signals to at least one power stage of the half-bridge arrangements.

Example 7. In a seventh example, the set of current sensing arrangements Rs1, Rs2 is configured to sense a voltage at a metal connection at a terminal of respective low-side DMOS transistors of the respective half-bridges during DMOS conduction.

Example 8. In an eight example, the control circuitry comprises:
at least one sample-and-hold, S&H circuit 124 coupled to at least one current estimating node 121, 122, Ix and to a plurality of capacitive elements Cs_n-1, Cs_n-2, Cx, Coff configured to store respective voltages V_Cs_n-1, V_Cs_n-2, Vx, Voff;
at least one comparator circuit 125 coupled to the S&H circuit to perform at least one comparison of stored voltages, providing as a result at least one comparison to a control logic circuit 110;
a buffer 126 coupled to the S&H circuit to receive stored voltage values therefrom;
a buffer capacitive element Cb referred to ground and being selectively couplable to the output of the buffer via a respective control switch *Saa* driven by a respective control signal from the control logic;
a further comparator circuit 128 having a first input node coupled to the buffer capacitive element and a second input node coupled to ground, the further comparator circuit configured to provide a delay signal Dell to the control logic to be applied to auxiliary Cs2 and driver signals, providing separate Cs2d and delayed H2dd control signals as a result.

Example 9. In a ninth example, the delay applied to the auxiliary control signal is equal to the time it takes to completely discharge a capacitance loaded at a respective stored voltage *Voff.*

Example 10. In a tenth example, a device D comprises:
- a PWM modulator PWMM configured FN, LF to receive an input signal I/V in and to produce therefrom first In_pwm1 and second In_pwm2 PWM-modulated drive signals,
- a circuit according to any of examples 1 to 9 coupled with the PWM modulator, with the first and second half bridges configured to be driven by said first and second PWM-modulated drive signals,
- respective low pass filter networks Lo1, C1; Lo2, C2 coupled to the output nodes of the first and second half bridges.

Example 11. In an eleventh example, the device comprises an electrical load L coupled to the circuit and supplied from the output nodes of the first and second half bridges via said respective low pass filter networks.

Example 12. In a twelfth example, a method of amplifying an input signal comprises:
- applying an input signal to a PWM modulator in a device according to example 10 or 11, and
- obtaining an amplified replica of the input signal at said respective low pass filter networks coupled to the output nodes of the first and second half bridges.

Without prejudice to the underlying principles, the details and embodiments may vary, even significantly, with respect to what has been described by way of example only without departing from the extent of protection.

The extent of protection is determined by the annexed claims.

## Claims

1. A circuit, comprising:
- a switching circuit stage comprising first (HB1) and second (HB2) half bridges comprising a first, high-side DMOS transistor (H1, H2) and a second, low-side DMOS transistor (L1, L2), the first half bridge (HB1) and the second half bridge (HB2) comprising respective output nodes (Vout1, Vout2) between the high-side DMOS transistor (H1, H2) and the low-side DMOS transistor (L1, L2) therein, the output nodes (Vout1, Vout2) configured for supplying an electrical load (L) via respective filter networks (Lo1, C1; LO2, C2) between the output nodes (Vout1, Vout2) and the load (L);
- control circuitry (60) coupled to the switching circuit stage and configured to control (Cs1, Cs2, RiseLate, RiseEarly) switching sequences (In_pwm) of the high-side (H1, H2) and low-side (L1, L2) transistors in the first (HB1) and second (HB2) half bridges wherein a first pair of DMOS transistors comprising the high-side DMOS transistor (H2 resp. H1) in one (HB2 resp. HB1) of the half bridges (HB1, HB2) and the low-side DMOS transistor (L1 resp. L2) in the other (HB1, resp. HB2) of the half bridges (HB1, HB2) is switched to a non-conductive state, and a second pair of transistors comprising the high-side DMOS transistor (H1 resp. H2) in the other (HB1 resp. HB2) of the half bridges (HB1, HB2) and the low-side DMOS transistor (L2 resp. L1) in the one (HB2 resp. HB1) of the half bridges (HB1, HB2) is switched to a conductive state,
wherein the circuit comprises:
- a current flow line between the output nodes (Vout 1, Vout2) in the first half bridge (HB1) and the second half bridge (HB2), the current flow line comprising an inductance (Laux) having opposed terminals coupled to a first switch (S1) and a second switch (S2), the first switch (S1) and the second switch (S2) selectively switchable between a non-conductive state and at least one conductive state,
- first and second capacitances (Caux1, Caux2; CparH1, CparL1, CparH2, CparL2) coupled with the output nodes (Vout1, Vout2) of the first half bridge (HB1) and the second half bridge (HB2), and
wherein the control circuitry (60) is configured to switch (H1d, H2d) the first (S1) and second (S2) switches to the at least one conductive state at intervals (ta, tb; t1, t2) in said switching sequences between switching the first pair of DMOS transistors (H1, L2) to a non-conductive state and switching the second pair of DMOS transistors (L1, H2) to a conductive state,
wherein the control circuitry (60) is configured to provide control signals (H1d, H2d) to switch at least one of said first (S1) and second (S2) switches based on at least one comparison signal indicative of a delay (Δ) among a first output signal at said first output node (Vout1) and a second output signal at said second output node (Vout2).

2. The circuit of claim 1, wherein the control circuitry (60) comprises:
a set of comparators (61, 62) having respective first comparator input nodes coupled to output nodes (Vout1, Vout2) of the first (HB1) and second (HB2) half-bridge circuits to receive the first (Vout1) and second (Vout2) output signals therefrom, the set of comparators (61, 62) having respective second comparator input nodes coupled to at least one reference voltage level (Vdd/2) as well as respective comparator output nodes coupled to a logic circuit block (64) to provide said at least one comparison signal indicative of the delay (Δ) among the first output signal at said first output node (Vout1) and the second output signal at said second output node (Vout2),
wherein the logic circuit block (64) is coupled to the set of comparators (61, 62) to receive the at least one comparison signal therefrom,
wherein the control circuitry (60) further comprises a set of control switches (S_{RSL1}, S_{RSE1}, S_{A}, S_{B}, S_{C}) coupled to the logic circuit block (64) to receive therefrom a respective set of switch control signals (RiseLate, RiseEarly, res, ctr_b, ctr_c) based on said at least one comparison signal.

3. The circuit of claim 2, further comprising:
a set of reference current generators (65, 66, 68) coupled to a first subset of control switches (S_{RSL}, S_{RSE}, S_{C}) in the set of control switches (S_{RSL}, S_{RSE}, S_{A}, S_{B}, S_{C}), the set of reference current generators (65, 66, 68) configured to provide reference currents (Iref) along a current flow line towards ground (GND);
an operational amplifier stage (67) having a first input node (+) coupled to an intermediate node (A) interposed first subset of control switches (S_{RSL}, S_{RSE}, S_{C}) in the set of control switches (S_{RSL}, S_{RSE}, S_{A}, S_{B}, S_{C}), the operational amplifier (67) arranged as a buffer having a second input node (-) coupled to the amplifier output node (B);
a first capacitive element (C_{A}) coupled to the intermediate node (A) and a second capacitive element (C_{B}) selectively couplable to the amplifier output node (B) via a respective control switch (S_{B});
a third comparator (69), preferably a window comparator, having an input node coupled to one end (C) of the second capacitor (C_{B}) referred to ground (GND) and a second input node coupled to ground (GND), the third comparator (69) configured to provide at least one additional control signal (H1d, H2d) to at least one power stage (H1, L2) of the half-bridge arrangements (HB1, HB2),
wherein the control circuitry (60) is configured to:
performing a comparison (61, 62) of at least one of said output signal (Voutl, Vout2) from respective half-bridge circuits (HB1, HB2) and a threshold value (Vdd/2), obtaining as a result of the comparison at least one first switch control signal (RiseLate, RiseEarly) in the set of set of switch control signals (RiseLate, RiseEarly, res, ctr_b, ctr_c);
based on the at least one first switch control signal (RiseLate, RiseEarly), charging (S_{RSL}) or discharging (S_{RSE}) the first capacitive element (C_{A}) via a reference current provided by a reference current generator in the set of reference current generators (65, 66);
transferring (res, S_{A}) the voltage on the first capacitive element (C_{A}) to the second capacitive element (C_{B}) via the operational amplifier stage (67), and
discharging (ctr_b, S_{B}) the second capacitor (C_{B}) using said reference current (Iref) provided by a reference current generator in the set of reference current generators (65, 66);
providing (ctr_c, S_{C}) to at least one power stage (H1, L2) of the half-bridge arrangements (HB1, HB2) the at least one additional control signal (H1d, H2d) based on the signal at the one end (C) of the second capacitor (C_{B}) referred to ground (GND).

4. The circuit of claim 3, wherein the set of control switches (S_{RSL}, S_{RSE}, S_{A}, S_{B}, S_{C}) comprises:
a first switch (S_{RSL}) configured to selectively couple a first reference current generator (65) in the set of reference current generators (65, 66, 68) to said intermediate node (A) based on a first control signal (RiseLate) received from the control logic (64);
a second switch (S_{RSE}) configured to selectively couple a second reference current generator (66) in the set of reference current generators (65, 66, 68) to said intermediate node (A) based on a second control signal (RiseEarly) received from the control logic (64);
a third switch (S_{A}) configured to selectively couple said intermediate node (A) to ground (GND) based on a reset control signal (res);
a fourth switch (S_{B}) configured to selectively couple amplifier output node (B) and the signal at one end (C) of the second capacitor (C_{B}) therebetween based on control signal (ctr_b) from the control logic (64);
a fifth switch (S_{C}) configured to selectively couple the one end (C) of the second capacitor (C_{B}) to the third reference current generator (68) based on a further control signal (ctr_c) received from control logic (64).

5. The circuit of any one of the previous claims, comprising:
a filter circuit (72) configured to detect variation of the time-distance among fronts of signals (Vout1, Vout2) and coupled to driver-generating amplification circuitry (74) comprising a plurality of power stages,
wherein, in response to the filter circuit 72 indicating that the delay among the signal fronts (Vout1, Vout2) is greater than a threshold, a reduced number of power stages are activated for the driver-generating amplification circuitry (74).

6. The circuit of claim 1, wherein the control circuitry (60) comprises:
a set of current sensing arrangements (Rs1, Rs2) configured to measure the respective voltage drops at respective sensing nodes (Vsens1, Vsens2) across respective low-side DMOS transistors (LS1, LS2) of the respective half-bridges (HB1, HB2);
a reference resistance (Rh) coupled to a reference current generator (114) configured to provide reference current (Iref), the reference resistance (Rh) being selectively couplable (Swon1, Swon2) to the respective sensing nodes (Vsens1, Vsens2) of the set of current sensing arrangements (Rs1, Rs2);
a set of coupling switches (SWOn1, SWOn2) configured to couple each respective sensing arrangement to the respective low-side DMOS (LS1, LS2) during respective DMOS conduction;
a first comparator circuit (112) having a first comparator input node coupled to a first voltage node (V1p) and a second comparator input node coupled to a second voltage node (V1n) interposed a further reference current generator (114) and a replica of reference resistance (Rh), thereby providing reference voltage level (Vref) at the second comparator node; the first comparator circuit (112) is further configured to provide at a comparator output node (K1) the difference among its input signals, which is therefore equal to the sensing voltage (Vsens);
a second comparator circuit (114) having respective comparator input nodes coupled to a third voltage node (V2p) and ground (GND), the second comparator circuit (114) being further configured to provide at a comparator output node (K2) the difference among its input nodes (V2p, GND);
wherein:
the first voltage node (V1p) is selectively couplable, via a first control switch (Sw1), to a capacitive element (Cd) referred to ground (GND);
the third voltage node (V2p) is coupled to the capacitive element (Cd) and is selectively couplable, via a second control switch (Sw2), to a resistive element (Rd) referred to ground (GND), and
the second voltage node (V1n) is selectively couplable, via a third control switch (Sw3), to the third voltage node (V2p);
the control circuitry further comprises a logic circuit block (110) coupled to the high-side switch (H2), to the auxiliary switch driver (Cs2), and to first and second comparators (112, 114), the logic circuit block (110) configured to apply respective delays (Tdel_main, Tdel_aux) based on the received output signals from comparators 112, 114, thereby providing separate (Cs1d) and additional (H2dd) control signals to at least one power stage (H1, L2) of the half-bridge arrangements (HB1, HB2).

7. The circuit of claim 6, wherein the set of current sensing arrangements (Rs1, Rs2) is configured to sense a voltage at a metal connection at a terminal of respective low-side DMOS transistors (LS1, LS2) of the respective half-bridges (HB1, HB2) during DMOS conduction.

8. The circuit of claim 1, wherein the control circuitry (60) comprises:
at least one sample-and-hold, S&H circuit (124) coupled to at least one current estimating node (121, 122, Ix) and to a plurality of capacitive elements (Cs_n-1, Cs_n-2, Cx, Coff) configured to store respective voltages (V_Cs_n-1, V_Cs_n-2, Vx, Voff);
at least one comparator circuit (125) coupled to the S&H circuit (124) to perform at least one comparison of stored voltages (V_Cs_n-1, V_Cs_n-2, Vx, Voff), providing as a result at least one comparison to a control logic circuit (110);
a buffer (126) coupled to the S&H circuit (125) to receive stored voltage values therefrom,
a buffer capacitive element (Cb) referred to ground (GND) and being selectively couplable to the output of the buffer (126) via a respective control switch (Saa) driven by a respective control signal from the control logic (110);
a further comparator circuit (128) having a first input node coupled to the buffer capacitive element (Cb) and a second input node coupled to ground (GND), the further comparator circuit (128) configured to provide a delay signal (Dell) to the control logic (110) to be applied to auxiliary (Cs2) and driver signals, providing separate (Cs2d) and delayed (H2dd) control signals as a result.

9. The circuit of claim 8, wherein the delay applied to the auxiliary control signal (Cs2d) is equal to the time it takes to completely discharge a capacitance loaded at a respective stored voltage (Voff).

10. A device (D), comprising:
- a PWM modulator (PWMM) configured (FN, LF) to receive an input signal (I/V in) and to produce therefrom first (In_pwm1) and second (In_pwm2) PWM-modulated drive signals,
- a circuit according to any of claims 1 to 9 coupled with the PWM modulator (PWMM) with the first (HB1) and second (HB2) half bridges configured to be driven by said first (In_pwm1) and second (In_pwm2) PWM-modulated drive signals,
- respective low pass filter networks (Lo1, C1; Lo2, C2) coupled to the output nodes (Vout1, Vout2) of the first (HB1) and second (HB2) half bridges.

11. The device (D) of claim 10, comprising an electrical load (L) coupled to the circuit and supplied from the output nodes (Vout1, Vout2) of the first (HB1) and second (HB2) half bridges via said respective low pass filter networks (Lo1, C1; Lo2, C2).

12. A method of amplifying an input signal (I/V in), the method comprising:
- applying an input signal (I/V in) to a PWM modulator (PWMM) in a device according to claim 10 or claim 11, and
- obtaining an amplified replica of the input signal (I/V in) at said respective low pass filter networks (Lo1, C1; Lo2, C2) coupled to the output nodes (Vout1, Vout2) of the first (HB1) and second (HB2) half bridges.
